# EUROPEAN PATENT APPLICATION

(11) **EP 4 593 017 A1**
(43) Date of publication of application: **30.07.2025**
(21) Application number: 23954970.2
(22) Date of filing: 31.10.2023
(51) Int. Cl.: G11C 19/28

(54) **SHIFT REGISTER UNIT, GATE DRIVE CIRCUIT, AND CONTROL METHOD**

(71) Applicant: BOE TECHNOLOGY GROUP CO., LTD., Beijing 100015 (CN); Hefei BOE Joint Technology Co., Ltd., Hefei, Anhui 230012 (CN); Beijing BOE Technology Development Co., Ltd., Daxing District Beijing 100176 (CN)
(72) Inventor: FENG, Xuehuan, Beijing 100176 (CN); LI, Yongqian, Beijing 100176 (CN)
(74) Representative: AWA Sweden AB
(86) International application number: PCT/CN2023/128273
(87) International publication number: WO 2025/091210

(57) **Abstract**

A shift register unit (200, 300) and a control method thereof, and a gate driving circuit (400). The shift register unit (200, 300) includes an input circuit (210, 310), a first control circuit (220, 320), a second control circuit (230, 330), an output circuit (240, 340), and at least one of a first adjustment circuit (250, 350) and a second adjustment circuit (260, 360). The input circuit (210, 310) is used to provide a signal to the first pull-down node (QB1) and a signal to the first pull-up node (Q1). The first control circuit (220, 320) is used to control a signal of the first pull-up node (Q1) and a signal of the first pull-down node (QB1). The second control circuit (230, 330) is used to control a signal of a second pull-down node (QB2) and a signal of a second pull-up node (Q2). The output circuit (240, 340) is used to provide a signal of one of a clock signal terminal (GCK) and a reference signal terminal (VGL) to an output signal terminal (GOUT) under control of the second pull-down node (QB2) and the second pull-up node (Q2). The first adjustment circuit (250, 350) is coupled to the first pull-down node (QB1) and the second control circuit (230, 330). The second adjustment circuit (260, 360) is coupled to the second pull-down node (QB2) and the output circuit (240, 340).

## Description

### TECHNICAL FIELD

The present disclosure relates to a field of display technology, and in particular, to a shift register unit, a gate driving circuit, and a method for controlling a shift register unit.

### BACKGROUND

In a display field, gate driving circuits are used to provide driving signals to sub-pixels, and the sub-pixels emit light based on data signals under control of the driving signals, thereby achieving image display. However, in display devices, especially in organic light-emitting diode (OLED) display devices, output signals of various shift registers in the gate driving circuit are often unstable for various reasons, which affects the display effect.

### SUMMARY

Embodiments of the present disclosure provide a shift register unit, including: an input circuit coupled to an input signal terminal of the shift register unit, a reference signal terminal of the shift register unit, a first pull-down node of the shift register unit, and a first pull-up node of the shift register unit, and configured to provide a signal of the input signal terminal to the first pull-up node and a signal of the reference signal terminal to the first pull-down node; a first control circuit coupled to the first pull-down node and the first pull-up node, and configured to control a signal of the first pull-up node based on the first pull-down node, and control a signal of the first pull-down node based on the first pull-up node; a second control circuit coupled to the first pull-down node of the shift register unit, the first pull-up node of the shift register unit, a second pull-down node of the shift register unit, and a second pull-up node of the shift register unit, and configured to provide the signal of the first pull-down node to the second pull-down node under control of the reference signal terminal, and control a signal of the second pull-up node based on the first pull-up node; an output circuit coupled to the second pull-down node, the second pull-up node, the reference signal terminal, a clock signal terminal of the shift register unit, and an output signal terminal of the shift register unit, and configured to provide a signal of one of the clock signal terminal and the reference signal terminal to the output signal terminal under control of the second pull-down node and the second pull-up node; and at least one of a first adjustment circuit and a second adjustment circuit, wherein the first adjustment circuit is coupled to the first pull-down node and the second control circuit, and the second adjustment circuit is coupled to the second pull-down node and the output circuit.

For example, the first adjustment circuit is configured to decrease a potential of the first pull-down node after the first pull-down node is reset, and the second adjustment circuit is configured to decrease a potential of the second pull-down node after the second pull-down node is reset.

For example, the second control circuit includes: a first control sub-circuit coupled to the first pull-down node, a first control signal terminal of the shift register unit, and a third pull-up node of the shift register unit, and configured to provide a signal of the first control signal terminal to the third pull-up node under control of the first pull-down node; a second control sub-circuit coupled to the reference signal terminal, the first pull-down node, and the second pull-down node, and configured to provide the signal of the first pull-down node to the second pull-down node under control of the signal of the reference signal terminal; a third control sub-circuit coupled to the first pull-up node, the reference signal terminal, and the third pull-up node, and configured to provide the signal of the reference signal terminal to the third pull-up node under control of the first pull-up node; and a fourth control sub-circuit coupled to the second pull-up node, the third pull-up node, and a second control signal terminal of the shift register unit, and configured to provide a signal of the third pull-up node to the second pull-up node under control of the signal of the first pull-up node and a signal of the second control signal terminal.

For example, the first control sub-circuit includes a first transistor, a gate of the first transistor is coupled to the first pull-down node, a first electrode of the first transistor is coupled to the first control signal terminal, and a second electrode of the first transistor is coupled to the third pull-up node; wherein the second control sub-circuit includes a second transistor, a gate of the second transistor is coupled to the reference signal terminal, a first electrode of the second transistor is coupled to the first pull-down node, and a second electrode of the second transistor is coupled to the second pull-down node; wherein the third control sub-circuit includes a third transistor, a gate of the third transistor is coupled to the first pull-up node, a first electrode of the third transistor is coupled to the reference signal terminal, and a second electrode of the third transistor is coupled to the third pull-up node; and wherein the fourth control sub-circuit includes a fourth transistor and a fifth transistor, a gate of the fourth transistor is coupled to the first pull-up node, a first electrode of the fourth transistor is coupled to the third pull-up node, and a second electrode of the fourth transistor is coupled to the second pull-up node; a gate of the fifth transistor is coupled to the second control signal terminal, a first electrode of the fifth transistor is coupled to the third pull-up node, and a second electrode of the fifth transistor is coupled to the second pull-up node.

For example, the first adjustment circuit includes a sixth transistor and a first capacitor; and wherein the sixth transistor and the first capacitor are coupled in series between the first pull-down node and the third pull-up node, and a gate of the sixth transistor is coupled to a third control signal terminal.

For example, a first electrode of the sixth transistor is coupled to the third pull-up node, a second electrode of the sixth transistor is coupled to a first electrode of the first capacitor, and a second electrode of the first capacitor is coupled to the first pull-down node.

For example, a first electrode of the first capacitor is coupled to the third pull-up node, a second electrode of the first capacitor is coupled to a first electrode of the sixth transistor, and a second electrode of the sixth transistor is coupled to the first pull-down node.

For example, the second adjustment circuit includes a seventh transistor, a second capacitor, and a third capacitor; and wherein a gate of the seventh transistor is coupled to a fourth control signal terminal of the shift register unit, a first electrode of the seventh transistor is coupled to a second control signal terminal of the shift register unit, a second electrode of the seventh transistor is coupled to a first electrode of the second capacitor, a second electrode of the second capacitor is coupled to the second pull-down node, a first electrode of the third capacitor is coupled to the reference signal terminal, and a second electrode of the third capacitor is coupled to the second electrode of the seventh transistor.

For example, the second adjustment circuit further includes an eighth transistor and a ninth transistor; and wherein a gate of the eighth transistor is coupled to the reference signal terminal, the second electrode of the second transistor is coupled to a first electrode of the eighth transistor at an intermediate node, a second electrode of the eighth transistor is coupled to the second pull-down node; a gate of the ninth transistor is coupled to the second pull-down node, a first electrode of the ninth transistor is coupled to the reference signal terminal, and a second electrode of the ninth transistor is coupled to the intermediate node.

For example, the reference signal terminal includes a first reference signal terminal and a second reference signal terminal, and a potential of the second reference signal terminal is lower than a potential of the first reference signal terminal; and wherein the input circuit is coupled to the first reference signal terminal or the second reference signal terminal, and the output circuit is coupled to the first reference signal terminal.

For example, the second adjustment circuit includes a seventh transistor, a second capacitor, and a third capacitor; and wherein a first electrode of the third capacitor is coupled to the first reference signal terminal.

For example, the second adjustment circuit further includes an eighth transistor and a ninth transistor; and wherein a first electrode of the ninth transistor is coupled to the second reference signal terminal.

For example, the input circuit includes a tenth transistor and an eleventh transistor; wherein a gate of the tenth transistor is coupled to a first control signal terminal, a first electrode of the tenth transistor is coupled to the first reference signal terminal or the second reference signal terminal, and a second electrode of the tenth transistor is coupled to the first pull-down node; and wherein a gate of the eleventh transistor is coupled to the first control signal terminal, a first electrode of the eleventh transistor is coupled to the input signal terminal, and a second electrode of the eleventh transistor is coupled to the first pull-up node.

For example, at least one of the tenth transistor and the second transistor is a low temperature poly-silicon transistor.

For example, the output circuit includes a twelfth transistor, a thirteenth transistor, and a fourth capacitor; wherein a gate of the twelfth transistor is coupled to the second pull-down node, a first electrode of the twelfth transistor is coupled to the reference signal terminal, and a second electrode of the twelfth transistor is coupled to the output signal terminal; wherein a gate of the thirteenth transistor is coupled to the second pull-up node, a first electrode of the thirteenth transistor is coupled to the clock signal terminal, and a second electrode of the thirteenth transistor is coupled to the output signal terminal; and wherein a first electrode of the fourth capacitor is coupled to the second pull-up node, and a second electrode of the fourth capacitor is coupled to the output signal terminal.

For example, the shift register unit further includes a cascaded output circuit coupled to the first pull-down node, the first pull-up node, a power signal terminal, a second control signal terminal of the shift register unit, and a cascaded output terminal of the shift register unit, and configured to provide a signal of one of the power signal terminal and the second control signal terminal to the cascaded output terminal under control of the first pull-down node and the first pull-up node.

For example, the cascaded output circuit includes a fourteenth transistor, a fifteenth transistor, a fifth capacitor, and a sixth capacitor.

For example, the cascaded output circuit further includes a sixteenth transistor, a gate of the fifteenth transistor is coupled to the sixteenth transistor at the first pull-up node, a gate of the sixteenth transistor is coupled to the reference signal terminal, a first electrode of the sixteenth transistor is coupled to the first pull-up node, and a second electrode of the sixteenth transistor is coupled to the gate of the fifteenth transistor.

For example, the first control circuit includes a seventeenth transistor, an eighteenth transistor, and a nineteenth transistor; wherein a gate of the seventeenth transistor is coupled to the first pull-up node, a first electrode of the seventeenth transistor is coupled to a first control signal terminal, and a second electrode of the seventeenth transistor is coupled to the first pull-down node; wherein a gate of the eighteenth transistor is coupled to the first pull-down node, a first electrode of the eighteenth transistor is coupled to a power signal terminal, and a second electrode of the eighteenth transistor is coupled to a first electrode of the nineteenth transistor; and wherein a gate of the nineteenth transistor is coupled to a second control signal terminal, and a second electrode of the nineteenth transistor is coupled to the first pull-up node.

For example, at least one transistor in the input circuit, the first control circuit, the second control circuit, the first adjustment circuit, the second adjustment circuit, and the output circuit is a P-type transistor.

Embodiments of the present disclosure provide another shift register unit, including: an input circuit coupled to an input signal terminal of the shift register unit, a power signal terminal of the shift register unit, a first pull-down node of the shift register unit, and a first pull-up node of the shift register unit, and configured to provide a signal of the input signal terminal to the first pull-down node and a signal of the power signal terminal to the first pull-up node; a first control circuit coupled to the first pull-down node and the first pull-up node, and configured to control a signal of the first pull-up node based on the first pull-down node, and control a signal of the first pull-down node based on the first pull-up node; a second control circuit coupled to the first pull-down node of the shift register unit, the first pull-up node of the shift register unit, a second pull-down node of the shift register unit, and a second pull-up node of the shift register unit, and configured to control a signal of the second pull-down node based on the first pull-down node, and provide the signal of the first pull-up node to the second pull-up node under control of the power signal terminal; an output circuit coupled to the second pull-down node, the second pull-up node, the power signal terminal, a reference signal terminal of the shift register unit, and an output signal terminal of the shift register unit, and configured to provide a signal of one of the power signal terminal and the reference signal terminal to the output signal terminal under control of the second pull-down node and the second pull-up node; and at least one of a first adjustment circuit and a second adjustment circuit, wherein the first adjustment circuit is coupled to the first pull-down node and the second control circuit, and the second adjustment circuit is coupled to the second pull-down node and the output circuit.

For example, the first adjustment circuit is configured to increase a potential of the first pull-down node after the first pull-down node is reset, and the second adjustment circuit is configured to increase a potential of the second pull-down node after the second pull-down node is reset.

For example, the second control circuit includes: a first control sub-circuit coupled to the first pull-up node, the first pull-down node, the power signal terminal, a first control signal terminal of the shift register unit, and a third pull-down node of the shift register unit, and configured to provide a signal of one of the power signal terminal and the first control signal terminal to the third pull-up node under control of the first pull-down node and the first pull-up node; a second control sub-circuit coupled to the first pull-up node, the first pull-down node, the reference signal terminal, a second control signal terminal of the shift register unit, and a fourth pull-up node of the shift register unit, and configured to provide a signal of one of the reference signal terminal and the second control signal terminal to the fourth pull-up node under control of the first pull-down node and the first pull-up node; a third control sub-circuit coupled to the second pull-up node, the fourth pull-up node, and the second control signal terminal, and configured to provide a signal of the fourth pull-up node to the second pull-up node under control of a signal of the second control signal terminal; and a fourth control sub-circuit coupled to the power signal terminal, the first pull-down node, and the second pull-down node, and configured to provide the signal of the first pull-down node to the second pull-down node under control of the signal of the power signal terminal.

For example, the first control sub-circuit includes a first transistor and a second transistor, a gate of the first transistor is coupled to the first pull-up node, a first electrode of the first transistor is coupled to the power signal terminal, and a second electrode of the first transistor is coupled to the third pull-up node; a gate of the second transistor is coupled to the first pull-down node, a first electrode of the second transistor is coupled to the first control signal terminal, and a second electrode of the second transistor is coupled to the third pull-up node; wherein the second control sub-circuit includes a third transistor, a fourth transistor, a first capacitor, and a second capacitor, a gate of the third transistor is coupled to the first pull-up node, a first electrode of the third transistor is coupled to the second control signal terminal, and a second electrode of the third transistor is coupled to the fourth pull-up node; a first electrode of the first capacitor is coupled to the first pull-up node, and a second electrode of the first capacitor is coupled to the fourth pull-up node; a gate of the fourth transistor is coupled to the first pull-down node, a first electrode of the fourth transistor is coupled to the reference signal terminal, and a second electrode of the fourth transistor is coupled to the fourth pull-up node; a first electrode of the second capacitor is coupled to the first pull-down node, and a second electrode of the second capacitor is coupled to the reference signal terminal; wherein the third control sub-circuit includes a fifth transistor, a gate of the fifth transistor is coupled to the second control signal terminal, a first electrode of the fifth transistor is coupled to the fourth pull-up node, and a second electrode of the fifth transistor is coupled to the second pull-up node; and wherein the fourth control sub-circuit includes a sixth transistor, a gate of the sixth transistor is coupled to the power signal terminal, a first electrode of the sixth transistor is coupled to the first pull-down node, and a second electrode of the sixth transistor is coupled to the second pull-down node.

For example, the first adjustment circuit includes a seventh transistor and a third capacitor; and wherein the seventh transistor and the third capacitor are coupled in series between the first pull-down node and the third pull-up node, and a gate of the seventh transistor is coupled to a third control signal terminal.

For example, a first electrode of the seventh transistor is coupled to the third pull-up node, a second electrode of the seventh transistor is coupled to a first electrode of the third capacitor, and a second electrode of the third capacitor is coupled to the first pull-down node.

For example, a first electrode of the third capacitor is coupled to the third pull-up node, a second electrode of the third capacitor is coupled to a first electrode of the seventh transistor, and a second electrode of the seventh transistor is coupled to the first pull-down node.

For example, the second adjustment circuit includes an eighth transistor, a fourth capacitor, and a fifth capacitor; and wherein a gate of the eighth transistor is coupled to a fourth control signal terminal of the shift register unit, a first electrode of the eighth transistor is coupled to a second control signal terminal of the shift register unit, a second electrode of the eighth transistor is coupled to a first electrode of the fourth capacitor, a second electrode of the fourth capacitor is coupled to the second pull-down node, a first electrode of the fifth capacitor is coupled to the power signal terminal, and a second electrode of the fifth capacitor is coupled to the second electrode of the eighth transistor.

For example, the second control circuit further includes a ninth transistor, a gate of the ninth transistor is coupled to the first pull-down node, a first electrode of the ninth transistor is coupled to the reference signal terminal, and a second electrode of the ninth transistor is coupled to the second pull-up node.

For example, the input circuit includes a tenth transistor and an eleventh transistor; wherein a gate of the tenth transistor is coupled to a first control signal terminal, a first electrode of the tenth transistor is coupled to the power signal terminal, and a second electrode of the tenth transistor is coupled to the first pull-up node; and wherein a gate of the eleventh transistor is coupled to the first control signal terminal, a first electrode of the eleventh transistor is coupled to the input signal terminal, and a second electrode of the eleventh transistor is coupled to the first pull-down node.

For example, at least one of the eleventh transistor and the sixth transistor is a low temperature poly-silicon transistor.

For example, the output circuit includes a twelfth transistor, a thirteenth transistor, and a fourth capacitor; wherein a gate of the twelfth transistor is coupled to the second pull-up node, a first electrode of the twelfth transistor is coupled to the reference signal terminal, and a second electrode of the twelfth transistor is coupled to the output signal terminal; wherein a gate of the thirteenth transistor is coupled to the second pull-down node, a first electrode of the thirteenth transistor is coupled to the power signal terminal, and a second electrode of the thirteenth transistor is coupled to the output signal terminal; and wherein a first electrode of the fourth capacitor is coupled to the second pull-up node, and a second electrode of the fourth capacitor is coupled to the reference signal terminal.

For example, the output circuit further includes a fourteenth transistor and a fifteenth transistor; wherein the first electrode of the twelfth transistor is coupled to the reference signal terminal through the fourteenth transistor, a gate of the fourteenth transistor is coupled to the second pull-up node, a first electrode of the fourteenth transistor is coupled to the reference signal terminal, and a second electrode of the fourteenth transistor is coupled to the first electrode of the twelfth transistor; and wherein a gate of the fifteenth transistor is coupled to the output signal terminal, a first electrode of the fifteenth transistor is coupled to the power signal terminal, and a second electrode of the fifteenth transistor is coupled to the first electrode of the twelfth transistor.

For example, the first control circuit includes a sixteenth transistor, a seventeenth transistor, and an eighteenth transistor; wherein a gate of the sixteenth transistor is coupled to the first pull-down node , a first electrode of the sixteenth transistor is coupled to a first control signal terminal, and a second electrode of the sixteenth transistor is coupled to the first pull-up node; wherein a gate of the seventeenth transistor is coupled to the first pull-up node, a first electrode of the seventeenth transistor is coupled to the reference signal terminal, a second electrode of the seventeenth transistor is coupled to a first electrode of the eighteenth transistor; and wherein a gate of the eighteenth transistor is coupled to a second control signal terminal, and a second electrode of the eighteenth transistor is coupled to the first pull-down node.

For example, at least one transistor in the input circuit, the first control circuit, the second control circuit, the first adjustment circuit, the second adjustment circuit, and the output circuit is an N-type transistor.

Embodiments of the present disclosure further provide a method for controlling the shift register units as described above, including:
in an input phase, providing, by the input circuit, the signal of the input signal terminal to the first pull-up node and the signal of the reference signal terminal to the first pull-down node;
in an output phase, controlling, by the first control circuit, the signal of the first pull-up node based on the first pull-down node, and controlling the signal of the first pull-down node based on the first pull-up node; providing, by the second control circuit, the signal of the first pull-up node to the second pull-up node and the signal of the first pull-down node to the second pull-down node, so that the second pull-up node is at low level and the second pull-down node is at high level; providing, by the output circuit, the signal of the clock signal terminal to the output signal terminal under control of the second pull-up node and the second pull-down node; and
in a reset phase, controlling, by the first control circuit, the signal of the first pull-up node based on the first pull-down node, and controlling the signal of the first pull-down node based on the first pull-up node; providing, by the second control circuit, the signal of the first pull-up node to the second pull-up node and the signal of the first pull-down node to the second pull-down node, so that the second pull-up node changes from being at low level to being at high level and the second pull-down node changes from being at high level to being at low level; providing, by the output circuit, the signal of the reference signal terminal to the output signal terminal under control of the second pull-up node and the second pull-down node,
wherein in the reset phase, the first adjustment circuit decreases a potential of the first pull-down node after the first pull-down node changes from being at high level to being at low level, and/or the second adjustment circuit decreases a potential of the second pull-down node after the second pull-down node changes from being at high level to being at low level.

For example, the second control circuit is coupled to a first control signal terminal and a second control signal terminal, the first adjustment circuit is coupled to a third control signal terminal, and the second adjustment circuit is coupled to a fourth control signal terminal; and wherein a valid level duration of a signal of the first control signal terminal partially overlaps with a valid level duration of a signal of the third control signal terminal, so that in the reset phase, the first adjustment circuit decreases the potential of the first pull-down node after the first pull-down node changes from being at high level to being at low level under control of the third control signal terminal; and/or a valid level duration of a signal of the second control signal terminal partially overlaps with a valid level duration of a signal of the fourth control signal terminal, so that in the reset phase, the second adjustment circuit decreases the potential of the second pull-down node after the second pull-down node changes from being at a high level to being at low level under control of the fourth control signal terminal.

Embodiments of the present disclosure further provide another method for controlling the shift register units as described above, including:
in an input phase, providing, by the input circuit, the signal of the input signal terminal and the signal of the power signal terminal to the first pull-up node and the first pull-down node;
in an output phase, controlling, by the first control circuit, a potential of the first pull-up node based on the first pull-down node, and controlling a potential of the first pull-down node based on the first pull-up node; providing, by the second control circuit, the signal of the first pull-up node to the second pull-up node and the signal of the first pull-down node to the second pull-down node, so that the second pull-up node is at high level and the second pull-down node is at low level; providing, by the output circuit, a signal of the reference signal terminal to the output signal terminal under control of the second pull-up node and the second pull-down node; and
in a reset phase, controlling, by the first control circuit, the signal of the first pull-up node based on the first pull-down node, and controlling the signal of the first pull-down node based on the first pull-up node; providing, by the second control circuit, the signal of the first pull-up node to the second pull-up node and the signal of the first pull-down node to the second pull-down node, so that the second pull-up node changes from being at high level to being at low level and the second pull-down node changes from being at low level to being at high level; providing, by the output circuit, the signal of the power signal terminal to the output signal terminal under control of the second pull-up node and the second pull-down node,
wherein in the reset phase, the first adjustment circuit increases the potential of the first pull-down node after the first pull-down node changes from being at low level to being at high level, and/or the second adjustment circuit increases a potential of the second pull-down node after the second pull-down node changes from being at low level to being at high level.

For example, the second control circuit is coupled to a first control signal terminal and a second control signal terminal, the first adjustment circuit is coupled to a third control signal terminal, and the second adjustment circuit is coupled to a fourth control signal terminal; and wherein a valid level duration of a signal of the first control signal terminal partially overlaps with a valid level duration of a signal of the third control signal terminal, so that in the reset phase, the first adjustment circuit increases the potential of the first pull-down node after the first pull-down node changes from being at low level to being at high level under control of the third control signal terminal; and/or a valid level duration of a signal of the second control signal terminal partially overlaps with a valid level duration of a signal of the fourth control signal terminal, so that in the reset phase, the second adjustment circuit increases the potential of the second pull-down node after the second pull-down node changes from being at low level to being at high level under control of the fourth control signal terminal.

Embodiments of the present disclosure further provide a gate driving circuit including a plurality of cascaded shift register units, wherein the shift register unit is the shift register unit as described above.

### BRIEF DESCRIPTION OF THE DRAWINGS

FIG. 1 shows a schematic diagram of a pixel driving circuit according to embodiments of the present disclosure.
FIG. 2 shows a signal timing diagram of a pixel driving circuit according to embodiments of the present disclosure.
FIG. 3 shows a schematic block diagram of a shift register unit according to embodiments of the present disclosure.
FIGS. 4 to 6 show circuit diagrams of examples of shift register units according to embodiments of the present disclosure, respectively.
FIG. 7 shows a schematic block diagram of a shift register unit according to some other embodiments of the present disclosure.
FIGS. 8 to 9 show circuit diagrams of examples of shift register units according to some other embodiments of the present disclosure, respectively.
FIG. 10 shows a signal timing diagram of a shift register unit according to an embodiment of the present disclosure.
FIG. 11 shows a signal timing diagram of a shift register unit according to another embodiment of the present disclosure.
FIG. 12 shows a schematic block diagram of a gate driving circuit according to embodiments of the present disclosure.

### DETAILED DESCRIPTION OF EMBODIMENTS

Although the present disclosure will be fully described with reference to accompanying drawings containing preferred embodiments of the present disclosure, it should be understood that those of ordinary skill in the art can modify the disclosure described herein while obtaining the technical effects of the present disclosure. Therefore, it should be understood that the above description is a broad disclosure for those of ordinary skill in the art, and its content is not intended to limit exemplary embodiments described in the present disclosure.

In addition, in the following detailed description, for the convenience of explanation, many specific details are set forth to provide a comprehensive understanding of embodiments of the present disclosure. However, clearly, one or more embodiments may be implemented without these specific details. In other cases, well-known structures and devices are illustrated to simplify the accompanying drawings.

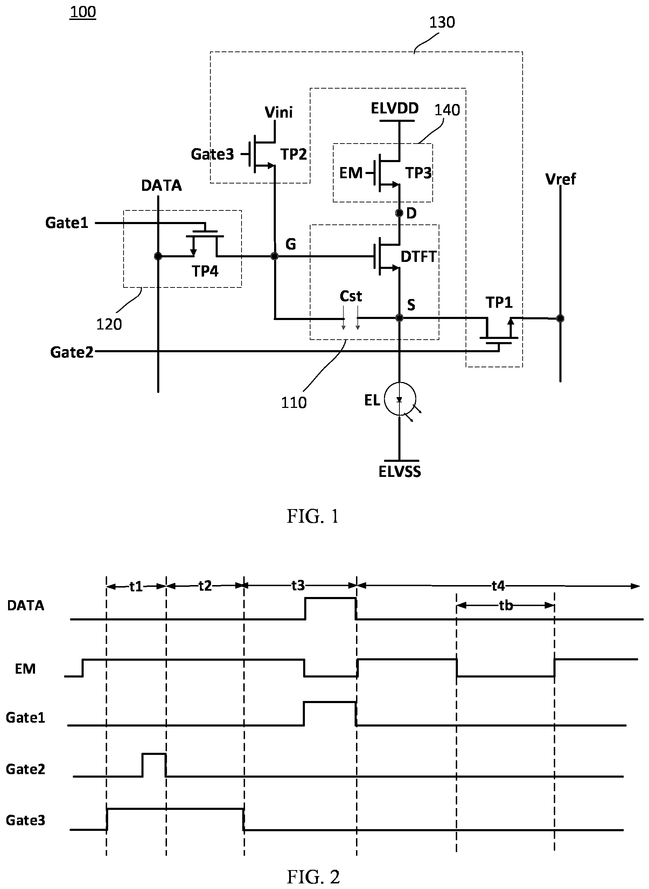

FIG. 1 shows a schematic diagram of a pixel driving circuit according to embodiments of the present disclosure.

As shown in FIG. 1, the pixel driving circuit 100 includes a driving circuit 110, an input circuit 120, a compensation circuit 130, and a light-emitting control circuit 140.

The driving circuit 110 has a control terminal G, a first terminal D, and a second terminal S. The driving circuit 110 is used to generate a driving current from the first terminal D to the second terminal S under control of a signal of the control terminal G. The driving circuit 110 may include a driving transistor DTFT and a capacitor Cst. A gate, a drain, and a source of the driving transistor DTFT serve as the control terminal G, the first terminal D, and the second terminal S of the driving circuit, respectively. For ease of description below, the gate, the drain, and the source of the driving transistor DTFT are also represented by G, D, and S, respectively. A first electrode of the capacitor Cst is coupled to the gate of the driving transistor DTFT, and a second electrode of the capacitor Cst is coupled to the second electrode of the driving transistor DTFT.

The input circuit 120 is coupled to a data signal terminal DATA and the control terminal G of the driving circuit. The input circuit 120 may provide a data signal at the data signal terminal DATA to the control terminal G of the driving circuit under control of a first gate driving signal Gate1. The input circuit 120 may include a fourth transistor TP4. The fourth transistor TP4 has a gate for receiving the first gate driving signal Gate1, a first electrode coupled to the data signal terminal DATA, and a second electrode coupled to the control terminal G of the driving circuit.

The compensation circuit 130 is coupled to a first voltage terminal Vini, a second voltage terminal Vref, and the control terminal G and second terminal S of the driving circuit 110. The compensation circuit 130 may provide a reference voltage at the second voltage terminal Vref to the second terminal S of the driving circuit under control of a second gate driving signal Gate2, and an initial voltage at the first voltage terminal Vini to the control terminal G of the driving circuit under control of a third gate driving signal Gate3. The compensation circuit 130 may include a first transistor TP1 and a second transistor TP2. The first transistor TP1 has a gate for receiving the second gate driving signal Gate2, a first electrode coupled to the second voltage terminal Vref, and a second electrode coupled to the second terminal S of the driving circuit. The second transistor TP2 has a gate for receiving the third gate driving signal Gate3, a first electrode coupled to the first voltage terminal Vini, and a second electrode coupled to the control terminal G of the driving circuit 110.

The light-emitting control circuit 140 is coupled between the first terminal D of the driving circuit 110 and a power signal terminal ELVDD. The light-emitting control circuit 140 may couple or decouple the first terminal D of the driving circuit 110 and the power signal terminal ELVDD under control of the light-emitting control signal EM. The light-emitting control circuit 140 may include a third transistor TP3. The third transistor TP3 has a gate for receiving the light-emitting control signal EM, a first electrode coupled to the power signal terminal ELVDD, and a second electrode coupled to the first terminal D of the driving circuit.

According to embodiments of the present disclosure, the pixel driving circuit 100 may be included in a sub-pixel and used for driving a light-emitting element in the sub-pixel to emit light. For example, as shown in FIG. 1, the second electrode S of the driving transistor DTFT in the pixel driving circuit 100 may be coupled to a first electrode (such as, an anode) of the light-emitting element EL. A second electrode (such as, a cathode) of the light-emitting element EL may be coupled to a reference signal terminal ELVSS. The light-emitting element EL may be an organic light-emitting diode OLED.

FIG. 2 shows a signal timing diagram of a pixel driving circuit according to embodiments of the present disclosure.

In a period t1, the first gate driving signal Gate1 is at low level, the second gate driving signal Gate2 and the third gate driving signal Gate3 are at high level, the fourth transistor TP4 is turned off, the first transistor TP1 and the second transistor TP2 are turned on, so that the gate G of the driving transistor DTFT is reset to be at a first voltage of the first voltage terminal Vini, and the source S of the driving transistor DTFT is reset to be at a second voltage of the second voltage terminal Vref. In this period, the high level of the second gate driving signal Gate2 may arrive later than the high level of the third gate driving signal Gate3, causing the gate G and source S of the driving transistor DTFT to be reset sequentially. Moreover, in this period, the light-emitting control signal EM may be at high level, so that the drain D of the driving transistor DTFT is reset to be at a reference voltage of the reference signal terminal ELVDD. In this period, the driving transistor DTFT is reset, therefore this period is also referred to as a reset period.

In a period t2, the third gate driving signal Gate3 and the light-emitting control signal EM remain at high level, and the second gate driving signal Gate2 changes to be at low level, so that the second transistor TP2 and the third transistor TP3 remain on and the first transistor TP1 is turned off. At this point, a gate-source voltage Vgs of the driving transistor DTFT is greater than a threshold voltage Vth of the driving transistor DTFT. The capacitor Cst charges the source S of the driving transistor DTFT until Vgs=Vth, thereby achieving compensation for the threshold voltage. This period is also referred to as a compensation period. In this period, the light-emitting control signal EM may remain at high level.

In a period t3, the third gate driving signal Gate3 changes to be at low level, and thus the second transistor TP2 is turned off. Then, the first gate driving signal Gate1 changes to be at high level, and the light-emitting control signal EM changes to be at low level, so that the third transistor TP3 and the fourth transistor TP4 are turned on. Therefore, when the data signal at the data signal terminal DATA arrives, the data signal is written into the gate G of the driving transistor DTFT. As shown in FIG. 2, the data signal at the data signal terminal DATA is shown as high level. However, those skilled in the art may be aware that this is only to indicate the arrival of the data signal, and the actual level of the data signal depends on the image data, not being a fixed level. In this period, the data signal is written into the gate G of the driving transistor DTFT, therefore this period is also referred to as a data writing period.

In a period t4, the light-emitting control signal EM changes to be at high level, the first gate driving signal Gate1 changes to be at low level, and the third transistor TP3 is turned on. At this point, the first transistor TP1, the second transistor TP2, and the fourth transistor TP4 are all turned off. The driving transistor DTFT generates a driving current from the drain D to the source S under the voltage of the gate G, and the generated driving current drives the light-emitting element EL to emit light. In some embodiments, a black insertion period tb may be provided in the period t4. In the black insertion period, the light-emitting control signal EM is at low level, and the third transistor TP3 is turned off, causing the driving transistor DTFT to stop generating current and the light-emitting element EL to stop emitting light. After the black insertion period tb ends, the light-emitting control signal EM returns to be at high level, thereby continuing to drive the light-emitting element EL to emit light. In some embodiments, the light-emitting control signal EM may be a multi-pulse signal for low grayscale dimming.

According to embodiments of the present disclosure, a compensation circuit and a light-emitting control circuit are provided in the pixel driving circuit, so that internal compensation may be achieved with lower cost and computational complexity as compared to performing compensation through complex calculations by a source driving circuit with external compensation function.

Embodiments of the present disclosure provide a shift register unit, including: an input circuit, a first control circuit, a second control circuit, an output circuit, and at least one of a first adjustment circuit and a second adjustment circuit. The input circuit is coupled to an input signal terminal of the shift register unit, a reference signal terminal of the shift register unit, a first pull-down node of the shift register unit, and a first pull-up node of the shift register unit, and used to provide a signal of the input signal terminal and a signal of the reference signal terminal to the first pull-up node and the first pull-down node. The first control circuit is coupled to the first pull-down node and the first pull-up node, and used to control a potential of the first pull-up node based on a potential of the first pull-down node, and control the potential of the first pull-down node based on the potential of the first pull-up node. The second control circuit is coupled to the first pull-down node, the first pull-up node, a second pull-down node of the shift register unit, and a second pull-up node of the shift register unit, and used to control a potential of the second pull-down node based on the potential of the first pull-down node, and control a potential of the second pull-up node based on the potential of the first pull-up node. The output circuit is coupled to the second pull-down node, the second pull-up node, the reference signal terminal, and a clock signal terminal of the shift register unit, and an output signal terminal of the shift register unit, and used to provide a signal of one of the clock signal terminal and the reference signal terminal to the output signal terminal under control of the second pull-down node and the second pull-up node. For the at least one of the first adjustment circuit and the second adjustment circuit, the first adjustment circuit is coupled to the first pull-down node and used to decrease the potential of the first pull-down node after the first pull-down node is reset, and the second adjustment circuit is coupled to the second pull-down node and used to decrease the potential of the second pull-down node after the second pull-down node is reset.

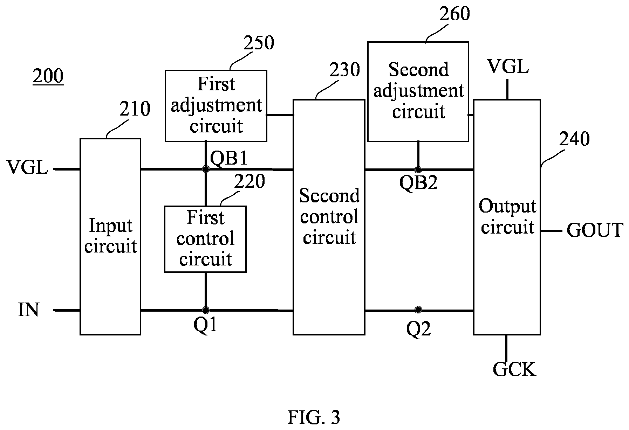

Hereinafter, a detailed illustration of this will be provided with reference to FIGS. 3 to 6.

FIG. 3 shows a schematic block diagram of a shift register unit according to embodiments of the present disclosure. Embodiments of the present disclosure provides a shift register unit capable of generating a scanning signal required for display driving, such as a gate driving signal or a light-emitting control signal, which may be applied to the pixel driving circuit with the internal compensation function or other circuits that require the scanning signal. For example, the generated scanning signal may be applied to the pixel driving circuit in above embodiments.

As shown in FIG. 3, the shift register unit 200 includes an input circuit 210, a first control circuit 220, a second control circuit 230, an output circuit 240, and at least one of a first adjustment circuit 250 and a second adjustment circuit 260. The shift register unit 200 may have an input signal terminal IN, an output signal terminal GOUT, a reference signal terminal VGL, a clock signal terminal GCK, a first pull-up node Q1, a second pull-up node Q2, a first pull-down node QB1, and a second pull-down node QB2.

The input circuit 210 is coupled to the input signal terminal IN, the reference signal terminal VGL, the first pull-up node Q1, and the first pull-down node QB1. The input circuit 210 may provide a signal of the input signal terminal IN to the first pull-up node Q1 and a signal of the reference signal terminal VGL to the first pull-down node QB1. In some embodiments, the input circuit 210 may include a first input sub-circuit and a second input sub-circuit. One of the first input sub-circuit and the second input sub-circuit is used to provide a signal of one of the input signal terminal IN and the reference signal terminal VGL to the first pull-up node Q1, and the other of the first input sub-circuit and the second input sub-circuit is used to provide a signal of the other of the input signal terminal IN and the reference signal terminal VGL to the first pull-down node QB1.

The first control circuit 220 is coupled to the first pull-up node Q1 and the first pull-down node QB1. The first control circuit 220 may control a signal of the first pull-down node QB1 based on the first pull-up node Q1 and control a signal of the first pull-up node Q1 based on the first pull-down node QB1. In some embodiments, the first control circuit 220 may include a pull-up node control sub-circuit and a pull-down node control sub-circuit, one of the pull-up node control sub-circuit and the pull-down node control sub-circuit is used to control the signal of the first pull-down node QB1 based on the first pull-up node Q1, and the other of the pull-up node control sub-circuit and the pull-down node control sub-circuit is used to control the signal of the first pull-up node Q1 based on the first pull-down node QB1.

The second control circuit 230 is coupled to the first pull-up node Q1, the first pull-down node QB1, the second pull-up node Q2, and the second pull-down node QB2. The second control circuit 230 may provide a signal of the first pull-down node QB1 to the second pull-down node QB2 under control of the reference signal terminal VGL, and control a potential of the second pull-up node Q2 based on the first pull-up node Q1. In some embodiments, the second control circuit 230 may include one or more of a first control sub-circuit, a second control sub-circuit, a third control sub-circuit, and a fourth control sub-circuit. For example, the second control circuit 230 may include the first control sub-circuit and the second control sub-circuit, or may include the first to third control sub-circuits, or may include the first to fourth control sub-circuits, which will be described in detail below.

The output circuit 240 is coupled to the second pull-up node Q2, the second pull-down node QB2, the clock signal terminal GCK, the reference signal terminal VGL, and the output signal terminal GOUT. The output circuit 240 may provide a signal of one of the clock signal terminal GCK and the reference signal terminal VGL to the output signal terminal GOUT under control of the second pull-up node Q2 and the second pull-down node QB2.

The first adjustment circuit 250 is coupled to the first pull-down node QB1 and the second control circuit 230. The first adjustment circuit 250 may adjust a potential of the first pull-down node QB1, for example, decrease the potential of the first pull-down node QB1 after the first pull-down node QB1 is reset.

The second adjustment circuit 260 is coupled to the second pull-down node QB2 and the output circuit 240. The second adjustment circuit 260 may adjust a potential of the second pull-down node QB2, for example, decrease the potential of the second pull-down node QB2 after the second pull-down node QB2 is reset.

According to embodiments of the present disclosure, each of the input circuit 210, the first control circuit 220, the second control circuit 230, the output circuit 240, the first adjustment circuit 250, and the second adjustment circuit 260 may include at least one P-type transistor.

In this way, embodiments of the present disclosure may implement a new shift register unit structure, in which the input circuit, first control circuit, second control circuit, output circuit, and first adjustment circuit and/or second adjustment circuit cooperate with each other to generate a scanning signal required for display driving, such as a gate driving signal or a light-emitting control signal. By providing at least one of the first adjustment circuit and the second adjustment circuit, the leakage phenomenon at the first pull-down node and/or the second pull-down node can be effectively alleviated.

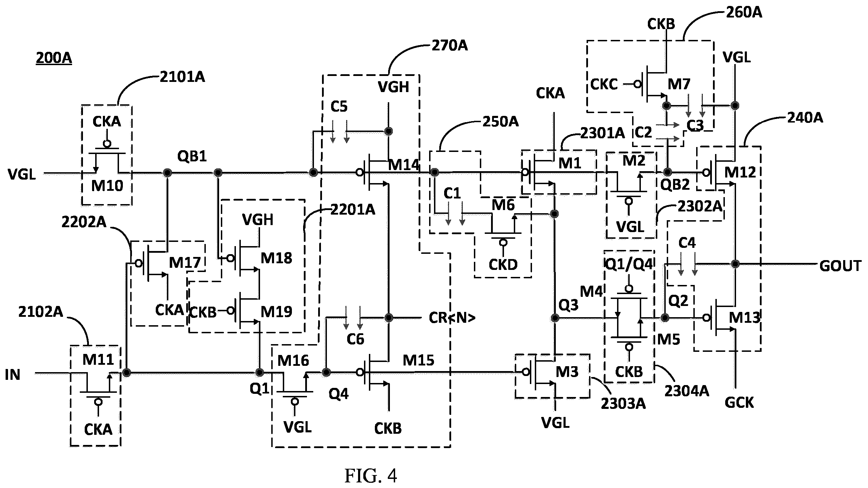

Hereafter, examples of shift register units in embodiments of the present disclosure will be described with reference to FIGS. 4 to 6.

FIG. 4 shows a circuit diagram of a shift register unit 200A according to an embodiment of the present disclosure. The shift register unit 200A includes an input circuit, a first control circuit, a second control circuit, an output circuit, a first adjustment circuit, and a second adjustment circuit. The description of the input circuit, the first control circuit, the second control circuit, the output circuit, and the first and second adjustment circuits in the embodiment shown in FIG. 3 is also applicable to the embodiment shown in FIG. 4.

As shown in FIG. 4, the input circuit includes a first input sub-circuit 2101A and a second input sub-circuit 2102A.

The first input sub-circuit 2101A is coupled to the reference signal terminal VGL, the first pull-down node QB1, and a first control signal terminal CKA of the shift register unit. The first input sub-circuit 2101A may provide a signal of the reference signal terminal VGL to the first pull-down node QB1 under control of the first control signal terminal CKA. The first input sub-circuit 2101A includes a tenth transistor M10. A gate of the tenth transistor M10 is coupled to the first control signal terminal CKA, a first electrode of the tenth transistor M10 is coupled to the reference signal terminal VGL, and a second electrode of the tenth transistor M10 is coupled to the first pull-down node QB1.

The second input sub-circuit 2102A is coupled to the input signal terminal IN, the first pull-up node Q1, and the first control signal terminal CKA. The second input sub-circuit 2102A may provide a signal of the input signal terminal IN to the first pull-up node Q1 under control of the first control signal terminal CKA. For example, the second input sub-circuit 2102A includes an eleventh transistor M11. A gate of the eleventh transistor M11 is coupled to the first control signal terminal CKA, a first electrode of the eleventh transistor M11 is coupled to the input signal terminal IN, and a second electrode of the eleventh transistor M11 is coupled to the first pull-up node Q1.

As shown in FIG. 4, the first control circuit includes a pull-up node control sub-circuit 2201A and a pull-down node control sub-circuit 2202A.

The pull-up node control sub-circuit 2201A is coupled to the first pull-up node Q1, the first pull-down node QB1, a power signal terminal VGH, and a second control signal terminal CKB of the shift register unit. The pull-up node control sub-circuit 2201A may provide a signal of the power signal terminal VGH to the first pull-up node Q1 under control of the second control signal terminal CKB and the first pull-down node QB1. For example, the pull-up node control sub-circuit 2201A may include an eighteenth transistor M18 and a nineteenth transistor M19. A gate of the eighteenth transistor M18 is coupled to the first pull-down node QB1, a first electrode of the eighteenth transistor M18 is coupled to the power signal terminal VGH, and a second electrode of the eighteenth transistor M18 is coupled to a first electrode of the nineteenth transistor M19. A gate of the nineteenth transistor M19 is coupled to the second control signal terminal CKB, and a second electrode of the nineteenth transistor M19 is coupled to the first pull-up node Q1.

The pull-down node control sub-circuit 2202A is coupled to the first pull-up node Q1, the first pull-down node QB1, and the first control signal terminal CKA. The pull-down node control sub-circuit 2202A may provide a signal of the first control signal terminal CKA to the first pull-down node QB1 under control of the first pull-up node Q1. For example, the pull-down node control sub-circuit 2202A may include a seventeenth transistor M17. A gate of the seventeenth transistor M17 is coupled to the first pull-up node Q1, a first electrode of the seventeenth transistor M17 is coupled to the first control signal terminal CKA, and a second electrode of the seventeenth transistor M17 is coupled to the first pull-down node QB1.

As shown in FIG. 4, the second control circuit includes a first control sub-circuit 2301A, a second control sub-circuit 2302A, a third control sub-circuit 2303A, and a fourth control sub-circuit 2304A.

The first control sub-circuit 2301A is coupled to the first pull-down node QB1, the first control signal terminal CKA, and a third pull-up node Q3 of the shift register unit. The first control sub-circuit 2301A may provide a signal of the first control signal terminal CKA to the third pull-up node Q3 under control of the first pull-down node QB1. For example, the first control sub-circuit 2301A may include a first transistor M1. A gate of the first transistor M1 is coupled to the first pull-down node QB1, a first electrode of the first transistor M1 is coupled to the first control signal terminal CKA, and a second electrode of the first transistor M1 is coupled to the third pull-up node Q3.

The second control sub-circuit 2302A is coupled to the reference signal terminal VGL, the first pull-down node QB1, and the second pull-down node QB2. The second control sub-circuit 2302A may provide a signal of the first pull-down node QB1 to the second pull-down node QB2 under control of a signal of the reference signal terminal VGL. For example, the second control sub-circuit 2302A may include a second transistor M2. A gate of the second transistor M2 is coupled to the reference signal terminal VGL, a first electrode of the second transistor M2 is coupled to the first pull-down node QB1, and a second electrode of the second transistor M2 is coupled to the second pull-down node QB2.

The third control sub-circuit 2303A is coupled to the first pull-up node Q1, the reference signal terminal VGL, and the third pull-up node Q3. The third control sub-circuit 2303A may provide a signal of the reference signal terminal VGL to the third pull-up node Q3 under control of the first pull-up node Q1. For example, the third control sub-circuit 2303A may include a third transistor M3. A gate of the third transistor M3 is coupled to the first pull-up node Q1, a first electrode of the third transistor M3 is coupled to the reference signal terminal VGL, and a second electrode of the third transistor M3 is coupled to the third pull-up node Q3.

The fourth control sub-circuit 2304A is coupled to the first pull-up node Q1 (or a fourth pull-up node Q4), the second pull-up node Q2, the third pull-up node Q3, and the second control signal terminal CKB. The fourth control sub-circuit 2304A may provide a signal of the third pull-up node Q3 to the second pull-up node Q2 under control of a signal of the first pull-up node Q1 and a signal of the second control signal terminal CKB. The fourth control sub-circuit 2304A includes a fourth transistor M4 and a fifth transistor M5. A gate of the fourth transistor M4 is coupled to the first pull-up node Q1 (or the fourth pull-up node Q4), a first electrode of the fourth transistor M4 is coupled to the third pull-up node Q3, and a second electrode of the fourth transistor M4 is coupled to the second pull-up node Q2. A gate of the fifth transistor M5 is coupled to the second control signal terminal CKB, a first electrode of the fifth transistor M5 is coupled to the third pull-up node Q3, and a second electrode of the fifth transistor M5 is coupled to the second pull-up node Q2. In some embodiments, the fourth control sub-circuit 2304A may include one of the fourth transistor M4 and the fifth transistor M5, as long as the fourth control sub-circuit 2304A can provide the signal of the third pull-up node Q3 to the second pull-up node Q2 under control of an appropriate control signal to cause the second pull-up node Q2 to have a desired waveform.

As shown in FIG. 4, the output circuit 240A may include a twelfth transistor M12, a thirteenth transistor M13, and a fourth capacitor C4.

A gate of the twelfth transistor M12 is coupled to the second pull-down node QB2, a first electrode of the twelfth transistor M12 is coupled to the reference signal terminal VGL, and a second electrode of the twelfth transistor M12 is coupled to the output signal terminal GOUT.

A gate of the thirteenth transistor M13 is coupled to the second pull-up node Q2, a first electrode of the thirteenth transistor M13 is coupled to the clock signal terminal GCK, and a second electrode of the thirteenth transistor M13 is coupled to the output signal terminal GOUT.

A first electrode of the fourth capacitor C4 is coupled to the second pull-up node Q2, and a second electrode of the fourth capacitor C4 is coupled to the output signal terminal GOUT.

As shown in FIG. 4, the first adjustment circuit 250A may include a sixth transistor M6 and a first capacitor C1. The sixth transistor M6 and the first capacitor C1 are coupled in series between the first pull-down node QB1 and the third pull-up node Q3. A gate of the sixth transistor M6 is coupled to a third control signal terminal CKD of the shift register unit. For example, a first electrode of the sixth transistor M6 is coupled to the third pull-up node Q3, a second electrode of the sixth transistor M6 is coupled to a first electrode of the first capacitor C1, and a second electrode of the first capacitor C1 is coupled to the first pull-down node QB1. In some embodiments, the first adjustment circuit 250A may include the sixth transistor M6 without the first capacitor C1, as long as the first adjustment circuit can adjust a potential of the first pull-down node QB1 under control of an appropriate control signal. For example, the first electrode of the sixth transistor M6 is coupled to the third pull-up node Q3, the second electrode of the sixth transistor M6 is coupled to the first pull-down node QB1, and the gate of the sixth transistor M6 may be coupled to an appropriate signal terminal as desired to receive a desired control signal, as long as the sixth transistor M6 can provide the signal of the third pull-up node Q3 to the first pull-down node QB1 at a desired time instant to achieve the goal of stabilizing the first pull-down node QB1.

As shown in FIG. 4, the second adjustment circuit 260A may include a seventh transistor M7, a second capacitor C2, and a third capacitor C3. A gate of the seventh transistor M7 is coupled to a fourth control signal terminal CKC of the shift register unit, a first electrode of the seventh transistor M7 is coupled to the second control signal terminal CKB of the shift register unit, a second electrode of the seventh transistor M7 is coupled to a first electrode of the second capacitor C2, a second electrode of the second capacitor C2 is coupled to the second pull-down node QB2, a first electrode of the third capacitor C3 is coupled to the reference signal terminal VGL, and a second electrode of the third capacitor C3 is coupled to the second electrode of the seventh transistor M7.

In some embodiments, the shift register unit may include a cascaded output circuit in addition to the input circuit, the first control circuit, the second control circuit, the output circuit, as well as the first adjustment circuit and/or the second adjustment circuit.

As shown in FIG. 4, the shift register unit 200A includes a cascaded output circuit 270A. The cascaded output circuit 270A is coupled to the first pull-down node QB1, the first pull-up node Q1, the power signal terminal VGH, the second control signal terminal CKB, and a cascaded output terminal CR<N>of the shift register unit. The cascaded output circuit 270A may provide a signal of one of the power signal terminal VGH and the second control signal terminal CKB to the cascaded output terminal CR<N> under control of the first pull-down node QB1 and the first pull-up node Q1.

The cascaded output circuit 270A may include a fourteenth transistor M14, a fifteenth transistor M15, a fifth capacitor C5, and a sixth capacitor C6. A gate of the fourteenth transistor M14 is coupled to the first pull-down node QB1, a first electrode of the fourteenth transistor M14 is coupled to the power signal terminal VGH, a second electrode of the fourteenth transistor M14 is coupled to the cascaded output terminal CR<N>, a first electrode of the fifth capacitor C5 is coupled to the first pull-down node QB1, and a second electrode of the fifth capacitor C5 is coupled to the power signal terminal VGH. A gate of the fifteenth transistor M15 is coupled to the first pull-up node Q1 (or the fourth pull-up node Q4), a first electrode of the fifteenth transistor M15 is coupled to the second control signal terminal CKB, a second electrode of the fifteenth transistor M15 is coupled to the cascaded output terminal CR<N>, a first electrode of the sixth capacitor C6 is coupled to the first pull-up node Q1 (or the fourth pull-up node Q4), and a second electrode of the sixth capacitor C6 is coupled to the cascaded output terminal CR<N>.

As shown in FIG. 4, the cascaded output circuit 270A may further include a sixteenth transistor M16. The gate of the fifteenth transistor M15 is coupled to the first pull-up node Q1 through the sixteenth transistor M16. A gate of the sixteenth transistor M16 is coupled to the reference signal terminal VGL, a first electrode of the sixteenth transistor M16 is coupled to the first pull-up node Q1, and a second electrode of the sixteenth transistor M16 is coupled to the gate of the fifteenth transistor M15.

At least one of the transistors in the embodiments described above with reference to FIG. 4 may be implemented by a P-type transistor, such as P-type Low Temperature Poly-Silicon (LTPS). For example, at least one of the transistors M10 and M2 is a P-type LTPS transistor. In some embodiments, all transistors in the shift register unit shown in FIG. 4 may be implemented by P-type LTPS transistors. Due to the fact that a signal for driving a sub-pixel is usually a high-level valid signal, how to use a P-type transistor to output a high-level valid pulse waveform has become a challenge. In addition, the off-state current of the LTPS transistor is too high, which may lead to leakage and cause the circuit to be unstable. According to embodiments described above with reference to FIG. 4, a shift register unit based on P-type transistors is provided, which may generate a high-level valid output signal, and by providing at least one of the first adjustment circuit and the second adjustment circuit, the leakage phenomenon at the first and/or second pull-down nodes is effectively alleviated, for example, by reducing the potential of the first and/or second pull-down nodes, the leakage time length of the transistors M10 and M2 is extended and the leakage speed is reduced.

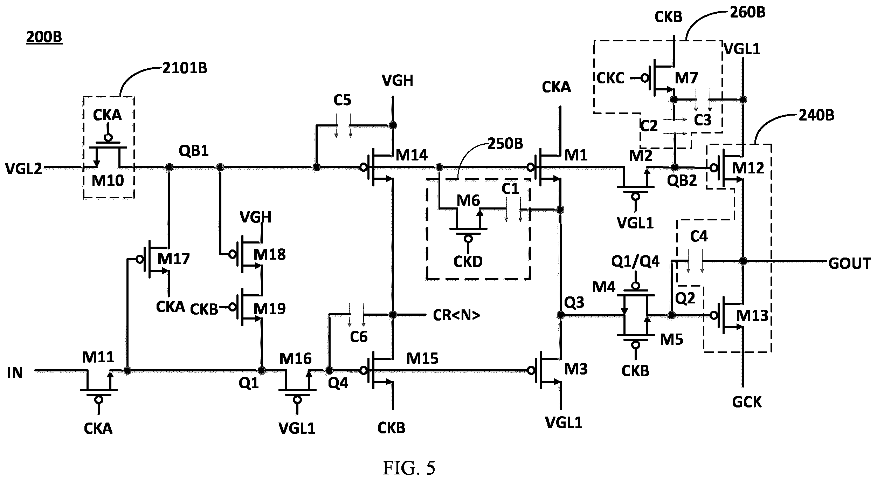

FIG. 5 shows a circuit diagram of a shift register unit 200B according to another embodiment of the present disclosure. The shift register unit 200B shown in FIG. 5 is similar to the shift register unit 200A shown in FIG. 4, except that at least the first adjustment circuit is different and the reference signal terminal is set differently. For the sake of simplicity and clarity, detailed description will be made mainly on the differences in the following.

As shown in FIG. 5, the first adjustment circuit 250B may include a sixth transistor M6 and a first capacitor C1. The sixth transistor M6 and the first capacitor C1 are coupled in series between the first pull-down node QB1 and the third pull-up node Q3. Unlike that shown in FIG. 4, a position of the sixth transistor M6 and a position of the first capacitor C1 are interchanged, that is, a first electrode of the first capacitor C1 is coupled to the third pull-up node Q3, a second electrode of the first capacitor C1 is coupled to a first electrode of the sixth transistor M6, a second electrode of the sixth transistor M6 is coupled to the first pull-down node QB1, and a gate of the sixth transistor M6 is coupled to the third control signal terminal CKD.

In some embodiments, the reference signal terminal VGL may include a first reference signal terminal VGL1 and a second reference signal terminal VGL2. A potential of the second reference signal terminal VGL2 is lower than a potential of the first reference signal terminal VGL1.

As shown in FIG. 5, the first input sub-circuit 2101B is coupled to the second reference signal terminal VGL2, and the first electrode of the tenth transistor M10 is coupled to the second reference signal terminal VGL2. The output circuit 240B is coupled to the first reference signal terminal VGL1, and the first electrode of the twelfth transistor M12 is coupled to the first reference signal terminal VGL1. The second adjustment circuit 260B is coupled to the first reference signal terminal VGL1, and the first electrode of the third capacitor C3 is coupled to the first reference signal terminal VGL1.

However, embodiments of the present disclosure are not limited to this. The first input sub-circuit may also be coupled to the first reference signal terminal VGL1, and the output circuit and the second adjustment circuit may also be coupled to the second reference signal terminal VGL2. Alternatively, the first input sub-circuit, the output circuit, and the second adjustment circuit may all be coupled to the second reference signal terminal VGL2. Alternatively, the first input sub-circuit, the output circuit, and the second adjustment circuit may all be coupled to the first reference signal terminal VGL1.

As shown in FIG. 5, a gate of the sixteenth transistor M16 is coupled to the first reference signal terminal VGL1, a first electrode of the third transistor M3 is coupled to the first reference signal terminal VGL1, and a gate of the second transistor M2 is coupled to the first reference signal terminal VGL1. However, embodiments of the present disclosure are not limited to this, and these transistors may also be coupled to the second reference signal terminal VGL2.

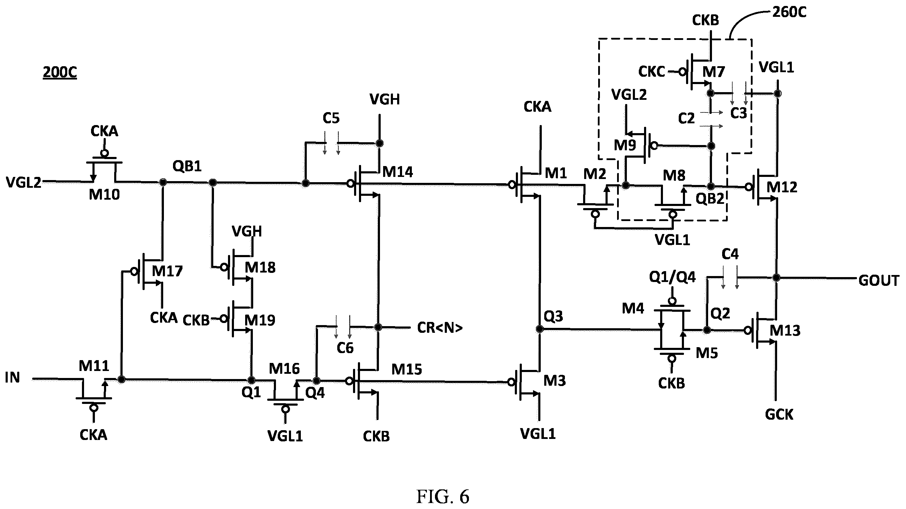

FIG. 6 shows a circuit diagram of a shift register unit 200C according to another embodiment of the present disclosure. The shift register unit 200C shown in FIG. 6 is similar to the shift register unit 200B shown in FIG. 5, except for the structure of the second adjustment circuit and that the shift register unit 200C shown in FIG. 6 does not include the first adjustment circuit. For the sake of simplicity and clarity, detailed description will be made mainly on the differences in the following.

As shown in FIG. 6, the second adjustment circuit 260C includes an eighth transistor M8 and a ninth transistor M9 in addition to the seventh transistor M7, the second capacitor C2, and the third capacitor C3. A gate of the eighth transistor M8 and the gate of the second transistor M2 included in the second control sub-circuit are coupled to the first reference signal terminal VGL1, the second electrode of the second transistor M2 is coupled to a first electrode of the eighth transistor M8 at an intermediate node, a second electrode of the eighth transistor M8 is coupled to the second pull-down node QB2. A gate of the ninth transistor M9 is coupled to the second pull-down node QB2, a first electrode of the ninth transistor is coupled to the second reference signal terminal VGL2, and a second electrode of the ninth transistor M9 is coupled to the intermediate node.

In some embodiments, the gate of the eighth transistor M8 and the gate of the second transistor M2 included in the second control sub-circuit may also be coupled to the second reference signal terminal VGL2, and the first electrode of the ninth transistor may also be coupled to the first reference signal terminal VGL1. Alternatively, the gate of the eighth transistor M8, the gate of the second transistor M2 included in the second control sub-circuit, and the first electrode of the ninth transistor may all be coupled to the first reference signal terminal VGL1. Alternatively, the gate of the eighth transistor M8, the gate of the second transistor M2 included in the second control sub-circuit, and the first electrode of the ninth transistor may all be coupled to the second reference signal terminal VGL2.

In some embodiments, the shift register unit may include not only the second adjustment circuit 260C shown in FIG. 6, but also the first adjustment circuit 250A shown in FIG. 4 or the first adjustment circuit 250B shown in FIG. 5.

In some embodiments, at least one of the tenth transistor M10 and the second transistor M2 is a LTPS transistor. However, embodiments of the present disclosure are not limited to this. In any of embodiments of the shift register units described above, at least one transistor may be a LTPS transistor. In some embodiments, the transistors M1 to M19 as described above may all be LTPS transistors.

Embodiments of the present disclosure further provide another shift register unit, including: an input circuit coupled to an input signal terminal of the shift register unit, a power signal terminal of the shift register unit, a first pull-down node of the shift register unit, and a first pull-up node of the shift register unit, and used to provide a signal of the input signal terminal and a signal of the power signal terminal to the first pull-down node and the first pull-up node; a first control circuit coupled to the first pull-down node and the first pull-up node, and used to control a potential of the first pull-up node based on a potential of the first pull-down node, and control the potential of the first pull-down node based on the potential of the first pull-up node; a second control circuit coupled to the first pull-down node, the first pull-up node, a second pull-down node of the shift register unit, and a second pull-up node of the shift register unit, and used to control a potential of the second pull-down node based on the potential of the first pull-down node, and control a potential of the second pull-up node based on the potential of the first pull-up node; an output circuit coupled to the second pull-down node, the second pull-up node, the power signal terminal, a reference signal terminal of the shift register unit, and an output signal terminal of the shift register unit, and used to provide a signal of one of the power signal terminal and the reference signal terminal to the output signal terminal under control of the second pull-down node and the second pull-up node; and at least one of a first adjustment circuit and a second adjustment circuit, where the first adjustment circuit is coupled to the first pull-down node and used to increase the potential of the first pull-down node after the first pull-down node is reset, and the second adjustment circuit is coupled to the second pull-down node and used to increase the potential of the second pull-down node after the second pull-down node is reset.

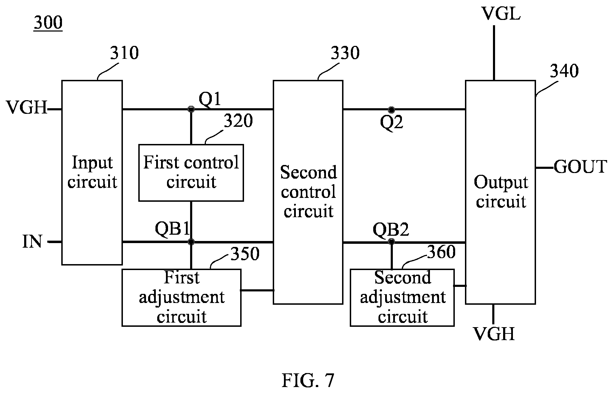

Hereinafter, a detailed description will be made with reference to FIGS. 7 to 9.

FIG. 7 shows a schematic block diagram of a shift register unit according to embodiments of the present disclosure. Embodiments of the present disclosure provides a shift register unit capable of generating a scanning signal required for display driving, such as a gate driving signal or a light-emitting control signal, which may be applied to the pixel driving circuit with the internal compensation function or other circuits that require the scanning signal. For example, the generated scanning signal may be applied to the pixel driving circuit in above embodiments.

As shown in FIG. 7, the shift register unit 300 includes an input circuit 310, a first control circuit 320, a second control circuit 330, an output circuit 340, and at least one of a first adjustment circuit 350 and a second adjustment circuit 360. The shift register unit 300 may have an input signal terminal IN, an output signal terminal GOUT, a reference signal terminal VGL, a power signal terminal VGH, a first pull-up node Q1, a second pull-up node Q2, a first pull-down node QB1, and a second pull-down node QB2.

The input circuit 310 is coupled to the input signal terminal IN, the power signal terminal VGH, the first pull-up node Q1, and the first pull-down node QB1. The input circuit 310 may provide a signal of the power signal terminal VGH to the first pull-up node Q1 and a signal of the input signal terminal IN to the first pull-down node QB1. In some embodiments, the input circuit 310 may include a first input sub-circuit and a second input sub-circuit. One of the first input sub-circuit and the second input sub-circuit is used to provide a signal of one of the input signal terminal IN and the power signal terminal VGH to the first pull-up node Q1, and the other of the first input sub-circuit and the second input sub-circuit is used to provide a signal of the other of the input signal terminal IN and the power signal terminal VGH to the first pull-down node QB1.

The first control circuit 320 is coupled to the first pull-up node Q1 and the first pull-down node QB1. The first control circuit 320 may control a signal of the first pull-down node QB1 based on the first pull-up node Q1 and control a signal of the first pull-up node Q1 based on the first pull-down node QB1. In some embodiments, the first control circuit 320 may include a pull-up node control sub-circuit and a pull-down node control sub-circuit. One of the pull-up node control sub-circuit and the pull-down node control sub-circuit is used to control a potential of the first pull-down node QB1 based on a potential of the first pull-up node Q1, and the other of the pull-up node control sub-circuit and the pull-down node control sub-circuit is used to control the potential of the first pull-up node Q1 based on the potential of the first pull-down node QB1.

The second control circuit 330 is coupled to the first pull-up node Q1, the first pull-down node QB1, the second pull-up node Q2, and the second pull-down node QB2. The second control circuit 330 may control a signal of the second pull-down node QB2 based on the first pull-down node QB1, and provide the signal of the first pull-up node Q1 to the second pull-up node Q2 under control of the power signal terminal VGH. In some embodiments, the second control circuit 330 may include one or more of a first control sub-circuit, a second control sub-circuit, a third control sub-circuit, and a fourth control sub-circuit. For example, the second control circuit 330 may include the first control sub-circuit and the second control sub-circuit, or may include the first to third control sub-circuits, or may include the first to fourth control sub-circuits, which will be described in detail below.

The output circuit 340 is coupled to the second pull-up node Q2, the second pull-down node QB2, the power signal terminal VGH, the reference signal terminal VGL, and the output signal terminal GOUT. The output circuit 340 may provide a signal of one of the power signal terminal VGH and the reference signal terminal VGL to the output signal terminal GOUT under control of the second pull-up node Q2 and the second pull-down node QB2.

The first adjustment circuit 350 is coupled to the first pull-down node QB1, and is used to increase the potential of the first pull-down node QB1 after the first pull-down node QB1 is reset.

The second adjustment circuit 360 is coupled to the second pull-down node QB2, and is used to increase the potential of the second pull-down node QB2 after the second pull-down node QB2 is reset.

According to embodiments of the present disclosure, each of the input circuit 310, the first control circuit 320, the second control circuit 330, the output circuit 340, the first adjustment circuit 350, and the second adjustment circuit 360 may include at least one N-type transistor.

In this way, embodiments of the present disclosure may implement a new shift register unit structure, in which the input circuit, first control circuit, second control circuit, output circuit, and first adjustment circuit and/or second adjustment circuit cooperate with each other to generate a scanning signal required for display driving, such as a gate driving signal or a light-emitting control signal. By providing at least one of the first adjustment circuit and the second adjustment circuit, the leakage phenomenon at the first pull-down node and/or the second pull-down node can be effectively alleviated.

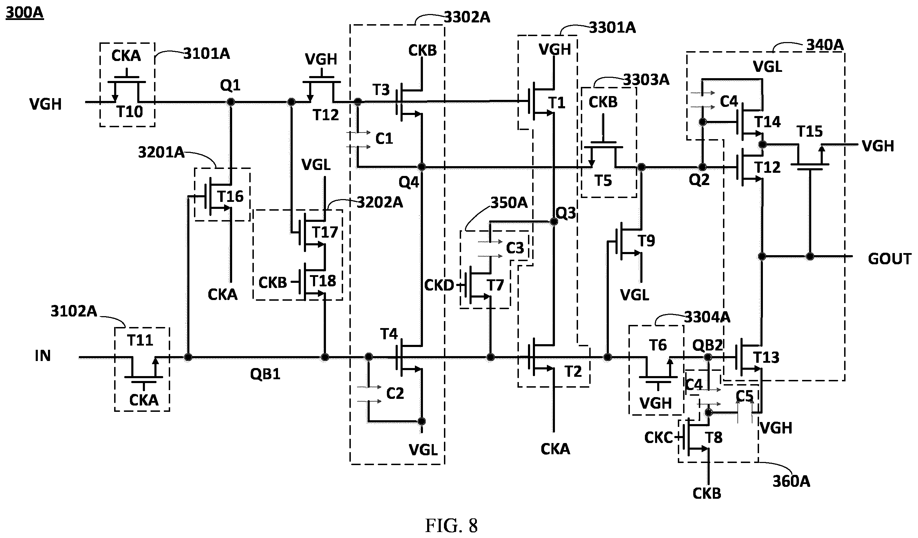

FIG. 8 shows a circuit diagram of a shift register unit 300A according to an embodiment of the present disclosure. The shift register unit 300A includes an input circuit, a first control circuit, a second control circuit, an output circuit, a first adjustment circuit, and a second adjustment circuit. The above description of the input circuit, the first control circuit, the second control circuit, the output circuit, and the first and second adjustment circuits in the embodiment shown in FIG. 7 is also applicable to the embodiment shown in FIG. 8.

As shown in FIG. 8, the input circuit includes a first input sub-circuit 3101A and a second input sub-circuit 3102A.

The first input sub-circuit 3101A is coupled to the power signal terminal VGH, the first pull-up node Q1, and a first control signal terminal CKA of the shift register unit. The first input sub-circuit 3101A may provide a signal of the power signal terminal VGH to the first pull-up node Q1 under control of the first control signal terminal CKA. The first input sub-circuit 3101A may include a tenth transistor T10. A gate of the tenth transistor T10 is coupled to the first control signal terminal CKA, a first electrode of the tenth transistor T10 is coupled to the power signal terminal VGH, and a second electrode of the tenth transistor T10 is coupled to the first pull-up node Q1.

The second input sub-circuit 3102A is coupled to the input signal terminal IN, the first pull-down node QB1, and the first control signal terminal CKA. The second input sub-circuit 3102A may provide a signal of the input signal terminal IN to the first pull-down node QB1 under control of the first control signal terminal CKA. For example, the second input sub-circuit 3102A includes an eleventh transistor T11. A gate of the eleventh transistor T11 is coupled to the first control signal terminal CKA, a first electrode of the eleventh transistor T11 is coupled to the input signal terminal IN, and a second electrode of the eleventh transistor T11 is coupled to the first pull-down node QB1.

As shown in FIG. 8, the first control circuit includes a pull-up node control sub-circuit 3201A and a pull-down node control sub-circuit 3202A.

The pull-up node control sub-circuit 3201A is coupled to the first pull-up node Q1, the first pull-down node QB1, and the first control signal terminal CKA. The pull-up node control sub-circuit 3201A may provide a signal of the first control signal terminal CKA to the first pull-up node Q1 under control of the first pull-down node QB1. For example, the pull-up node control sub-circuit 3201A may include a sixteenth transistor T16. A gate of the sixteenth transistor T16 is coupled to the first pull-down node QB1, a first electrode of the sixteenth transistor T16 is coupled to the first control signal terminal CKA, and a second electrode of the sixteenth transistor T16 is coupled to the first pull-up node Q1.

The pull-down node control sub-circuit 3202A is coupled to the first pull-up node Q1, the first pull-down node QB1, the reference signal terminal VGL, and a second control signal terminal CKB of the shift register unit. The pull-down node control sub-circuit 3202A may provide a signal of the reference signal terminal VGL to the first pull-down node QB1 under control of the first pull-up node Q1 and the second control signal terminal CKB. For example, the pull-down node control sub-circuit 3202A may include a seventeenth transistor T17 and an eighteenth transistor T18. A gate of the seventeenth transistor T17 is coupled to the first pull-up node Q1, a first electrode of the seventeenth transistor T17 is coupled to the reference signal terminal VGL, a second electrode of the seventeenth transistor T17 is coupled to a first electrode of the eighteenth transistor T18, a gate of the eighteenth transistor T18 is coupled to the second control signal terminal CKB, and a second electrode of the eighteenth transistor T18 is coupled to the first pull-down node QB1.

As shown in FIG. 8, the second control circuit includes a first control sub-circuit 3301A, a second control sub-circuit 3302A, a third control sub-circuit 3303A, and a fourth control sub-circuit 3304A.

The first control sub-circuit 3301A is coupled to the first pull-up node Q1, the first pull-down node QB1, the power signal terminal VGH, the first control signal terminal CKA, and a third pull-up node Q3 of the shift register unit. The first control sub-circuit 3301A may provide a signal of one of the power signal terminal VGH and the first control signal terminal CKA to the third pull-up node Q3 under control of the first pull-down node QB1 and the first pull-up node Q1. For example, the first control sub-circuit 3301A includes a first transistor T1 and a second transistor T2. A gate of the first transistor T1 is coupled to the first pull-up node Q1, a first electrode of the first transistor T1 is coupled to the power signal terminal VGH, a second electrode of the first transistor T1 is coupled to the third pull-up node Q3. A gate of the second transistor T2 is coupled to the first pull-down node QB1, a first electrode of the second transistor T2 is coupled to the first control signal terminal CKA, and a second electrode of the second transistor T2 is coupled to the third pull-up node Q3.

The second control sub-circuit 3302A is coupled to the first pull-up node Q1, the first pull-down node QB1, the reference signal terminal VGL, the second control signal terminal CKB of the shift register unit, and a fourth pull-up node Q4 of the shift register unit. The second control sub-circuit 3302A may provide a signal of one of the reference signal terminal VGL and the second control signal terminal CKB to the fourth pull-up node Q4 under control of the first pull-down node QB1 and the first pull-up node Q1. For example, the second control sub-circuit 3302A may include a third transistor T3, a fourth transistor T4, a first capacitor C1, and a second capacitor C2. A gate of the third transistor T3 is coupled to the first pull-up node Q1, a first electrode of the third transistor T3 is coupled to the second control signal terminal CKB, a second electrode of the third transistor T3 is coupled to the fourth pull-up node Q4, a first electrode of the first capacitor C1 is coupled to the first pull-up node Q1, a second electrode of the first capacitor C1 is coupled to the fourth pull-up node Q4, a gate of the fourth transistor T4 is coupled to the first pull-down node QB1, a first electrode of the fourth transistor T4 is coupled to the reference signal terminal VGL, a second electrode of the fourth transistor T4 is coupled to the fourth pull-up node Q4, a first electrode of the second capacitor C2 is coupled to the first pull-down node QB1, and a second electrode of the second capacitor C2 is coupled to the reference signal terminal VGL.

The third control sub-circuit 3303A is coupled to the second pull-up node Q2, the fourth pull-up node Q4, and the second control signal terminal CKB. The third control sub-circuit 3303A may provide the signal of the fourth pull-up node Q4 to the second pull-up node Q2 under control of the signal of the second control signal terminal CKB. For example, the third control sub-circuit 3303A includes a fifth transistor T5. A gate of the fifth transistor T5 is coupled to the second control signal terminal CKB, a first electrode of the fifth transistor T5 is coupled to the fourth pull-up node Q4, and a second electrode of the fifth transistor T5 is coupled to the second pull-up node Q2.

The fourth control sub-circuit 3304A is coupled to the power signal terminal VGH, the first pull-down node QB1, and the second pull-down node QB2. The fourth control sub-circuit 3304A may provide the signal of the first pull-down node QB1 to the second pull-down node QB2 under control of the signal of the power signal terminal VGH. The fourth control sub-circuit 3304A may include a sixth transistor T6. A gate of the sixth transistor T6 is coupled to the power signal terminal VGH, a first electrode of the sixth transistor T6 is coupled to the first pull-down node QB1, and a second electrode of the sixth transistor T6 is coupled to the second pull-down node QB2.

As shown in FIG. 8, the second control circuit further includes a ninth transistor T9. A gate of the ninth transistor T9 is coupled to the first pull-down node QB1, a first electrode of the ninth transistor T9 is coupled to the reference signal terminal VGL, and a second electrode of the ninth transistor T9 is coupled to the second pull-up node Q2.

As shown in FIG. 8, the output circuit 340A may include a twelfth transistor T12, a thirteenth transistor T13, and a fourth capacitor C4.

A gate of the twelfth transistor T12 is coupled to the second pull-up node Q2, a first electrode of the twelfth transistor T12 is coupled to the reference signal terminal VGL, and a second electrode of the twelfth transistor T12 is coupled to the output signal terminal GOUT.

A gate of the thirteenth transistor T13 is coupled to the second pull-down node QB2, a first electrode of the thirteenth transistor M13 is coupled to the power signal terminal VGH, and a second electrode of the thirteenth transistor T13 is coupled to the output signal terminal GOUT.

A first electrode of the fourth capacitor C4 is coupled to the second pull-up node Q2, and a second electrode of the fourth capacitor C4 is coupled to the reference signal terminal VGL.

As shown in FIG. 8, the output circuit 340A further includes a fourteenth transistor T14 and a fifteenth transistor T15. The first electrode of the twelfth transistor T12 is coupled to the reference signal terminal VGL through the fourteenth transistor T14. A gate of the fourteenth transistor is coupled to the second pull-up node Q2, a first electrode of the fourteenth transistor T14 is coupled to the reference signal terminal VGL, and a second electrode of the fourteenth transistor T14 is coupled to the first electrode of the twelfth transistor T12. A gate of the fifteenth transistor T15 is coupled to the output signal terminal GOUT, a first electrode of the fifteenth transistor T15 is coupled to the power signal terminal VGH, and a second electrode of the fifteenth transistor T15 is coupled to the first electrode of the twelfth transistor T12. By providing the fourteenth transistor T14 and the fifteenth transistor T15, leakage of the twelfth transistor T12 may be prevented. For example, when the second pull-up node Q2 is at low level and the output signal terminal GOUT is at high level, the twelfth transistor T12 is turned off. If the fourteenth transistor T14 and the fifteenth transistor T15 are not provided, the first electrode and the second electrode of the twelfth transistor T12 will be at high level and low level, respectively, causing a large voltage difference between the first electrode and the second electrode of the twelfth transistor T12 and resulting in leakage. By providing the fourteenth transistor T14 and the fifteenth transistor T15, the high level of the output signal terminal GOUT causes the fifteenth transistor T15 to be turned on, thereby causing both the first electrode and the second electrode of the twelfth transistor to be at high levels, so that the voltage difference between the first electrode and the second electrode of the twelfth transistor T12 is reduced. The low level of the second pull-up node Q2 causes the fourteenth transistor T14 to be turned off, thereby isolating the first electrode of the twelfth transistor T12 from the reference signal terminal VGL. Thus, the prevention of leakage is achieved.

As shown in FIG. 8, the first adjustment circuit 350A may include a seventh transistor T7 and a third capacitor C3. The seventh transistor T7 and the third capacitor C3 are coupled in series between the first pull-down node QB1 and the third pull-up node Q3. A first electrode of the third capacitor C3 is coupled to the third pull-up node Q3, a second electrode of the third capacitor C3 is coupled to the first electrode of the seventh transistor T7, a gate of the seventh transistor T7 is coupled to the third control signal terminal CKD of the shift register unit, and a second electrode of the seventh transistor T7 is coupled to the first pull-down node QB1.

As shown in FIG. 8, the second adjustment circuit 360A may include an eighth transistor T8, a fourth capacitor C4, and a fifth capacitor C5. A gate of the eighth transistor T8 is coupled to a fourth control signal terminal CKC of the shift register unit, a first electrode of the eighth transistor T8 is coupled to the second control signal terminal CKB of the shift register unit, a second electrode of the eighth transistor T8 is coupled to a first electrode of the fourth capacitor C4, a second electrode of the fourth capacitor C4 is coupled to the second pull-down node QB2, a first electrode of the fifth capacitor C5 is coupled to the power signal terminal VGH, and a second electrode of the fifth capacitor C5 is coupled to the second electrode of the eighth transistor T8.

In some embodiments, at least one of the sixth transistor T6 and the eleventh transistor T11 is a Low Temperature Poly-Silicon (LTPS) transistor. However, embodiments of the present disclosure are not limited to this. In any of embodiments of the shift register units described above, at least one transistor may be a LTPS transistor. In some embodiments, the transistors T1 to T18 as described above may all be LTPS transistors.

At least one of the transistors in embodiments described above with reference to FIG. 8 may be implemented by an N-type transistor, such as an N-type Low Temperature Poly-Silicon (LTPS). For example, at least one of the transistors T6 and T11 is an N-type LTPS transistor. In some embodiments, all transistors in the shift register unit shown in FIG. 8 may be implemented by N-type LTPS transistors. Due to the fact that a signal for driving a sub-pixel is usually a low-level valid signal, how to use an N-type transistor to output a low-level valid pulse waveform has become a challenge. In addition, the off-state current of the LTPS transistor is too high, which may lead to leakage and cause the circuit to be unstable. According to embodiments described above with reference to FIG. 8, a shift register unit based on N-type transistors is provided, which may generate a low-level valid output signal, and by providing at least one of the first adjustment circuit and the second adjustment circuit, the leakage phenomenon at the first and/or second pull-down nodes is effectively alleviated, for example, by increasing the potential of the first and/or second pull-down nodes, the leakage time length of the transistors T6 and T11 is extended and the leakage speed is reduced.

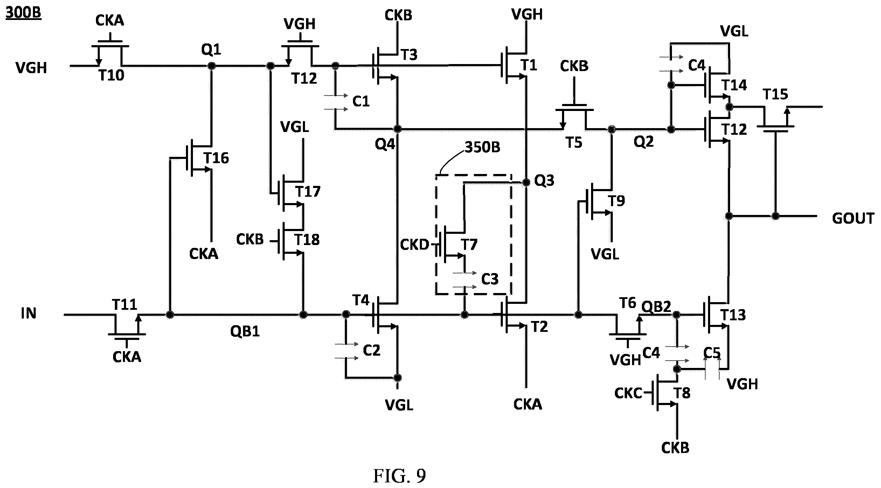

FIG. 9 shows a circuit diagram of a shift register unit 300B according to another embodiment of the present disclosure. The shift register unit 300B shown in FIG. 9 is similar to the shift register unit 300A shown in FIG. 8, except that at least the first adjustment circuit is different. For the sake of simplicity and clarity, detailed description will be made mainly on the differences in the following.

As shown in FIG. 9, the first adjustment circuit 350B may include a seventh transistor T7 and a third capacitor C3. The seventh transistor T7 and the third capacitor C3 are coupled in series between the first pull-down node QB1 and the third pull-up node Q3. Unlike that shown in FIG. 8, a position of the seventh transistor T7 and a position of the third capacitor C3 are interchanged, that is, a first electrode of the seventh transistor T7 is coupled to the third pull-up node Q3, a second electrode of the seventh transistor T7 is coupled to a first electrode of the third capacitor C3, a second electrode of the third capacitor C3 is coupled to the first pull-down node QB1, and a gate of the seventh transistor T7 is coupled to the third control signal terminal CKD.

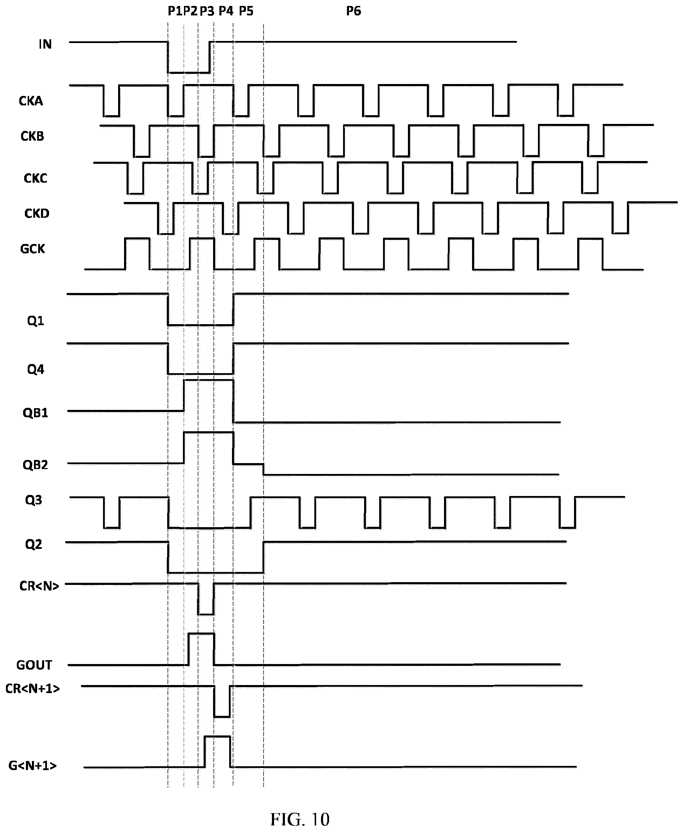

Embodiments of the present disclosure further provide a method for controlling a shift register unit, including: in an input phase, providing, by the input circuit, the signal of the input signal terminal and the signal of the reference signal terminal to the first pull-up node and the first pull-down node; in an output phase, controlling, by the first control circuit, the potential of the first pull-up node based on the potential of the first pull-down node, and controlling the potential of the first pull-down node based on the potential of the first pull-up node; providing, by the second control circuit, the signal of the first pull-up node to the second pull-up node and the signal of the first pull-down node to the second pull-down node, so that the second pull-up node is at low level and the second pull-down node is at high level; providing, by the output circuit, the signal of the clock signal terminal to the output signal terminal under control of the second pull-up node and the second pull-down node; and in a reset phase, controlling, by the first control circuit, the potential of the first pull-up node based on the potential of the first pull-down node, and controlling the potential of the first pull-down node based on the potential of the first pull-up node; providing, by the second control circuit, the signal of the first pull-up node to the second pull-up node and the signal of the first pull-down node to the second pull-down node, so that the second pull-up node changes from being at low level to being at high level and the second pull-down node changes from being at high level to being at low level; providing, by the output circuit, the signal of the reference signal terminal to the output signal terminal under control of the second pull-up node and the second pull-down node. In the reset phase, the first adjustment circuit decreases the potential of the first pull-down node after the first pull-down node changes from being at high level to being at low level, and/or the second adjustment circuit decreases the potential of the second pull-down node after the second pull-down node changes from being at high level to being at low level. Hereinafter, a detailed illustration of this will be provided with reference to a signal timing diagram of FIG. 10.

FIG. 10 shows a signal timing diagram of a shift register unit according to an embodiment of the present disclosure. The timing diagram may be applied to the shift register units based on P-type transistors of embodiments of the present disclosure to cause the shift register units to generate a gate driving signal or a light-emitting control signal. For ease of illustration, the following will take the shift register unit shown in FIG. 4 as an example. The control method may include an input phase, an output phase, and a reset phase. As shown in FIG. 10, the input phase includes a period P1, the output phase includes periods P2 to P4, and the reset phase includes periods P5 and P6.

In the period P1, the input signal terminal IN and the first control signal terminal CKA are at low levels, and the tenth transistor M10 and the eleventh transistor M11 are turned on, thereby providing the low level of the reference signal terminal VGL to the first pull-down node QB1 and the low level of the input signal terminal IN to the first pull-up node Q1. The low level of the first pull-up node Q1 causes the third transistor M3 to be turned on. As the sixteenth transistor M16 is turned on, the low level of the input signal terminal IN is written to the third pull-up node Q3. The low level of the first pull-up node Q1 and the fourth pull-up node Q4 causes the fourth transistor M4 to be turned on, so that the low level is written to the second pull-up node Q2. The low level of the second pull-up node Q2 causes the thirteenth transistor M13 to be turned on, thereby providing the low level of the clock signal terminal GCK to the output signal terminal GOUT. As the second transistor M2 is turned on, the low level of the reference signal terminal VGL is written to the second pull-down node QB2. The low level of the second pull-down node QB2 causes the twelfth transistor M12 to be turned on, thereby providing the low level of the reference signal terminal VGL to the output signal terminal GOUT, and the output signal terminal GOUT remains at low level.

In the period P2, the input signal terminal IN remains at low level, the first control signal terminal CKA changes to be at high level, the tenth transistor M10 and the eleventh transistor M11 are turned off, and the low level of the first pull-up node Q1 causes the seventeenth transistor M17 to be turned on, thereby providing the high level of the first control signal terminal CKA to the first pull-down node QB1 and the second pull-down node QB2. The low level of the first pull-up node Q1 keeps the third transistor M3 in a turned-on state. The turned on third transistor M3 and fourth transistor M4 keep the third pull-up node Q3 and the second pull-up node Q2 being at low levels, thereby keeping the thirteenth transistor M13 in a turned-on state. As the clock signal terminal GCK changes from being at low level to being at high level in the period P2, the output signal terminal GOUT follows the waveform of the clock signal terminal GCK and changes from being at low level to being at high level.

In the period P3, the first pull-up node Q1 and the second pull-up node Q2 remain at low levels, and the first pull-down node QB1 and the second pull-down node QB2 remain at high levels. The turned on thirteenth transistor M13 continues to provide the high level of the clock signal terminal GCK to the output signal terminal GOUT, thereby causing the output signal terminal GOUT to continue outputting high level. The turned on fifteenth transistor M15 provides low level of the second control signal terminal CKB to the cascaded output terminal CR, thereby causing the output signal CR<N> of the cascaded output terminal CR to be at low level.

In the period P4, the first pull-up node Q1 and the second pull-up node Q2 remain at low levels, and the first pull-down node QB1 and the second pull-down node QB2 remain at high levels. The turned on thirteenth transistor M13 provides the low level of the clock signal terminal GCK to the output signal terminal GOUT, thereby causing the output signal terminal GOUT to output low level.

In the period P5, the first control signal terminal CKA is at low level. In the duration when the first control signal terminal CKA is at low level, the tenth transistor M10 and the eleventh transistor M11 are turned on. The turned on tenth transistor M10 provides the low level of the reference signal terminal VGL to the first pull-down node QB1, and then the low level is provided to the second pull-down node QB2 through the turned on transistor M2. The turned on eleventh transistor M11 provides the high level of the input signal terminal IN to the first pull-up node Q1, and then the high level is provided to the fourth pull-up node Q4 through the turned on sixteenth transistor M16. The potential of the first pull-up node Q1 and the fourth pull-up node Q4 causes both the third transistor M3 and the fourth transistor M4 to be turned off, thereby keeping the second pull-up node Q2 being at low level. The low level of the second pull-up node Q2 causes the thirteenth transistor M13 to be turned off, and the low level of the second pull-down node QB2 causes the twelfth transistor M12 to be turned on, thereby providing the low level of the reference signal terminal VGL to the output signal terminal GOUT.

In the period P6, the first control signal terminal CKA is at high level, the tenth transistor M10 and the eleventh transistor M11 are both turned off, the first pull-down node QB1 and the second pull-down node QB2 remain at low levels, and the first pull-up node Q1 and the fourth pull-up node Q4 remain at high level. The low level of the first pull-down node QB1 causes the first transistor M1 to be turned on, thereby providing the high level of the first control signal terminal CKA to the third pull-down node Q3. The second control signal terminal CKB is at low level, and the fifth transistor M5 is turned on, thereby providing the high level of the third pull-up node Q3 to the second pull-down node Q2.

At this point, the shift register unit has completed the signal output.

As shown in FIG. 10, a valid level duration of the signal of the first control signal terminal CKA does not overlap with a valid level duration of the signal of the second control signal terminal CKB. In some embodiments, the valid level duration of the signal of the first control signal terminal CKA partially overlaps with the valid level duration of the signal of the third control signal terminal CKD, so that in the reset phase, the first adjustment circuit decreases the potential of the first pull-down node QB1 after the first pull-down node QB1 changes from being at high level to being at low level under control of the third control signal terminal CKD. For example, in a transition phase from the period P4 to the period P5 (which may be defined as a time period between a falling edge of the signal of the third control signal terminal CKA falling into the period P4 and a rising edge of the signal of the third control signal terminal CKA falling into the period P5), due to the partial overlap of the valid level duration of the signal of the third control signal terminal CKD and the valid level duration of the signal of the first control signal terminal CKA, the first control signal terminal CKA changes from being at high level to being at low level, and the third control signal terminal CKD remains at low level. The level change of the first control signal terminal CKA causes the tenth transistor M10 to be turned on and then to be turned off, thereby providing the low level of the reference signal terminal VGL to the first pull-down node QB1. The low level of the first pull-down node QB1 causes the first transistor M1 to be turned on, thereby providing the signal of the first control signal terminal CKA to the third pull-up node Q3, causing the third pull-up node Q3 to also change from being at high level to being at low level. As the third control signal terminal CKD remains at low level in the transition phase, the change from high level to low level of the third pull-up node Q3 is transmitted to the first electrode of the first capacitor C1, causing the first electrode of the first capacitor to change from being at high level to being at low level. The bootstrap effect of the first capacitor C1 further decreases the potential of the second electrode of the first capacitor, thereby causing the potential of the first pull-down node QB1 to be further reduced, that is, the potential of the first pull-down node QB1 is reduced to a level decrease than the level of the reference signal terminal VGL. After the transition phase ends (i.e., after the third control signal terminal CKD changes to be at high level), the sixth transistor M6 remains in a turned-off state, so that the potential of the first pull-down node QB1 is no longer affected by the level change of the third pull-up node Q3.

In some embodiments, the valid level duration of the signal of the second control signal terminal CKB partially overlaps with the valid level duration of the signal of the fourth control signal terminal CKC, so that in the reset phase, the second adjustment circuit decreases the potential of the second pull-down node QB2 after the second pull-down node QB2 changes from being at high level to being at low level under control of the fourth control signal terminal CKC. For example, in a transition phase from the period P5 to the period P6 (which may be defined as a time period between a falling edge of the signal of the fourth control signal terminal CKC falling into the period P5 and a rising edge of the signal of the fourth control signal terminal CKC falling into the period P6), the second control signal terminal CKB changes from being at high level to being at low level, the fourth control signal terminal CKC remains at low level, and the seventh transistor M7 is turned on, thereby transferring the change from high level to low level of the second control signal terminal CKB to the first electrode of the second capacitor C2. The level of the second pull-down node QB2 is further reduced by the bootstrap effect of the second capacitor C2, that is, the level of the second pull-down node QB2 is reduced to a level lower than the level of the reference signal terminal VGL. After the transition phase ends, that is, after the fourth control signal terminal CKC changes to be at high level, the seventh transistor M7 remains in a turned-off state, so that the potential of the second pull-down node QB2 is no longer affected by the level change of the second control signal terminal CKB.

In some embodiments, the gate of the seventh transistor M7 may also be coupled to the third control signal terminal CKD, and the first electrode of the seventh transistor M7 may also be coupled to the first control signal terminal CKA. In this case, similar to the first pull-down node QB1, the level of the second pull-down node QB2 will be further reduced to a level lower than the level of the reference signal terminal VGL in the period P5.

In embodiments of the present disclosure, at least one of the tenth transistor M10 and the second transistor M2 may be a LTPS transistor. When the second transistor M2 and the tenth transistor M10 are positively floating or at low frequencies, due to the characteristics of LTPS itself, leakage occurs in the off state, which leads to a leakage path in the reset phase, namely "second pull-down node QB2- first transistor M1- first pull-down node QB1 - tenth transistor M10-reference signal terminal VGL". Then, the potential of the second pull-down node QB2 will be pulled to the potential of the reference signal terminal VGL, and the threshold voltage of the twelfth transistor M12 in the output circuit is negative, therefore the twelfth transistor M12 cannot output a complete potential of VGL (Vgs-Vth>0, Vgs represents the gate-source voltage of the twelfth transistor, Vth represents the threshold voltage of the twelfth transistor M12). At this point, the output signal terminal GOUT is in a floating state, and the output is easily interfered by external signals or other AC signals, resulting in abnormal output and circuit failure.

In embodiments of the present disclosure, by providing at least one of the first adjustment circuit and the second adjustment circuit, a potential of at least one of the first pull-down node QB1 and the second pull-down node QB2 may be decreased in the reset phase, thereby prolonging the leakage time length of the tenth transistor M10 and/or the second transistor M2 and achieving the effect of preventing leakage.

In some embodiments, such as the shift register unit 200B shown in FIG. 5, the first electrode of the tenth transistor M10 is coupled to the second reference signal terminal VGL2, and the twelfth transistor M12 is coupled to the first reference signal terminal VGL1. As the potential of the second reference signal terminal VGL2 is lower than the potential of the first reference signal terminal VGL1, compared to the case that the tenth transistor M10 is coupled to the first reference signal terminal VGL1, the original leakage path "second pull-down node QB2- first transistor M1- first pull-down node QB1- tenth transistor M10- reference signal terminal VGL1" becomes "second pull-down node QB2- first transistor M1- first pull-down node QB1- tenth transistor M10- second reference signal terminal VGL2". In other words, compared to the case that the tenth transistor M10 is coupled to the first reference signal terminal VGL1, as the tenth transistor M10 is coupled to the second reference signal terminal VGL2, a lower potential may be provided to the second pull-down node QB2. While, by providing the first adjustment circuit and the second adjustment circuit, the potential of the first pull-down node QB1 and the potential the second pull-down node QB2 may be further decreased, the Vds (which represents the source-drain voltage of the transistor) of the tenth transistor M10 and the second transistor M2 may be reduced, and the leakage speed may be significantly reduced. In this way, it is ensured that the twelfth transistor M12 satisfies Vgs-Vth<0, and the output signal terminal GOUT will not be in a floating state, which may further stabilize the output.

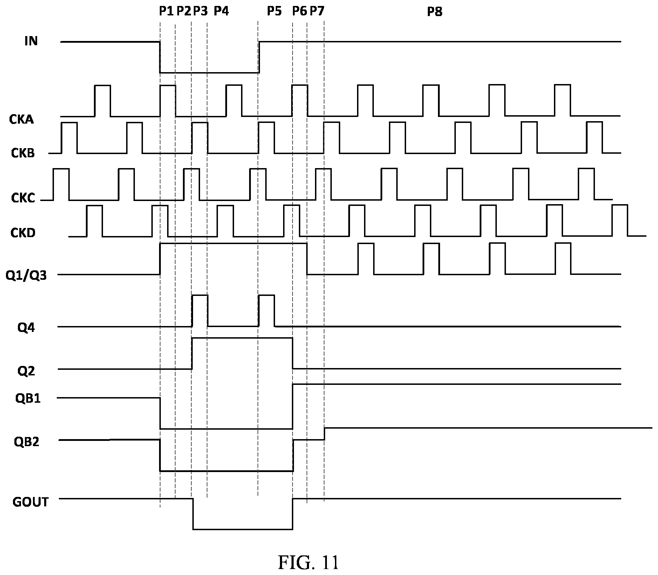

Embodiments of the present disclosure further provide a method for controlling a shift register unit, including: in an input phase, providing, by the input circuit, the signal of the input signal terminal and the signal of the power signal terminal to the first pull-up node and the first pull-down node; in an output phase, controlling, by the first control circuit, the potential of the first pull-up node based on the potential of the first pull-down node, and controlling the potential of the first pull-down node based on the potential of the first pull-up node; providing, by the second control circuit, the signal of the first pull-up node to the second pull-up node and the signal of the first pull-down node to the second pull-down node, so that the second pull-up node is at high level and the second pull-down node is at low level; providing, by the output circuit, the signal of the reference signal terminal to the output signal terminal under control of the second pull-up node and the second pull-down node; and in a reset phase, controlling, by the first control circuit, the potential of the first pull-up node based on the potential of the first pull-down node, and controlling the potential of the first pull-down node based on the potential of the first pull-up node; providing, by the second control circuit, the signal of the first pull-up node to the second pull-up node and the signal of the first pull-down node to the second pull-down node, so that the second pull-up node changes from being at high level to being at low level and the second pull-down node changes from being at low level to being at high level; providing, by the output circuit, the signal of the power signal terminal to the output signal terminal under control of the second pull-up node and the second pull-down node. In the reset phase, the first adjustment circuit increases the potential of the first pull-down node after the first pull-down node changes from being at low level to being at high level, and/or the second adjustment circuit increases the potential of the second pull-down node after the second pull-down node changes from being at low level to being at high level. Hereinafter, a detailed illustration of this will be provided with reference to FIG. 11.

FIG. 11 shows a signal timing diagram of a shift register unit according to another embodiment of the present disclosure. The timing diagram may be applied to the shift register units based on N-type transistors of embodiments of the present disclosure to cause the shift register units to generate a gate driving signal or a light-emitting control signal. For ease of illustration, the following will take the shift register unit shown in FIG. 8 as an example.

As shown in FIG. 11, similarly, the method includes an input phase, an output phase, and a reset phase. The input phase includes a period P1, the output phase includes periods P2 to P5, and the reset phase includes periods P6 to P8.

In the period P1, the input signal terminal IN is at low level, the first control signal terminal CKA is at high level, and the tenth transistor T10, twelfth transistor T12, first transistor T1, and eleventh transistor T11 are turned on, thereby providing the high level of the power signal terminal VGH to the first pull-up node Q1 and the low level of the input signal terminal IN to the first pull-down node QB1 and the second pull-down node QB2.

In the period P2, the input signal terminal IN remains at low level, the first control signal terminal CKA changes from being at high level to being at low level, and the tenth transistor T10 and the eleventh transistor T11 are turned off. The first pull-up node Q1 remains at high level, the first transistor T1 remains in a turned-on state, and the third pull-up node Q3 remains at high level.

In the period P3, the input signal terminal IN remains at low level, the first control signal terminal CKA remains at low level, and the second control signal terminal CKB changes from being at low level to being at high level. As the first pull-up node Q1 remains at high level, the third transistor T3 is in a turned-on state, thereby writing the high level of the second control signal terminal CKB into the fourth pull-up node Q4. The high level of the second control signal terminal CKB causes the fifth transistor T5 to be turned on, thereby writing the high level to the second pull-up node Q2. The high level of the second pull-up node Q2 causes the twelfth transistor T12 and the fourteenth transistor T14 to be turned on, thereby providing the low level of the reference signal terminal VGL to the output signal terminal GOUT.

In the period P4, the input signal terminal IN remains at low level, the first pull-up node Q1 and the second pull-up node Q2 remain at high levels, the first pull-down node QB1 and the second pull-down node QB2 remain at low levels, the twelfth transistor T12 is turned on, and the thirteenth transistor T13 is turned off, thereby keeping the output signal terminal GOUT being at low level.

In the period P5, the input signal terminal IN changes from being at low level to being at high level, the first control signal terminal CKA remains at low level, the tenth transistor M10 and the eleventh transistor M11 are in a turned-off state, therefore the first pull-up node Q1 and the second pull-up node Q2 still remain at high levels, the first pull-down node QB1 and the second pull-down node QB2 still remain at low levels, the twelfth transistor T12 is turned on, and the thirteenth transistor T13 is turned off, thereby keeping the output signal terminal GOUT being at low level.

In the period P6, the first control signal terminal CKA changes to be at high level, and both the tenth transistor T10 and the eleventh transistor T11 are turned on, thereby providing the high level of the power signal terminal VGH to the first pull-up node Q1, the high level of the input signal terminal IN to the first pull-down node QB1, and then to the second pull-down node QB2. The low level of the second control signal terminal CKB causes the fifth transistor T5 to be turned off, and the high level of the first pull-down node QB1 causes the ninth transistor T9 to be turned on, thereby providing the low level of the reference signal terminal to the second pull-up node Q2. The high level of the first pull-up node Q1 and the high level of the first pull-down node QB1 respectively cause the third transistor T3 and the fourth transistor T4 to be turned on, thereby causing the fourth pull-up node Q4 to be at low level. The low level of the second pull-up node Q2 causes both the twelfth transistor and the fourteenth transistor T14 to be turned off, and the high level of the second pull-down node QB2 causes the thirteenth transistor to be turned on, thereby outputting high level at the output signal terminal GOUT.

In the period P7, the first control signal terminal CKA changes to be at low level, and both the tenth transistor T10 and the eleventh transistor T11 are turned off. The high level of the first pull-down node QB1 causes the sixteenth transistor T16 to be turned on, thereby providing the low level of the first control signal terminal CKA to the first pull-up node Q1, thus completing the reset.

In some embodiments, a valid level duration of the signal of the first control signal terminal CKA partially overlaps with a valid level duration of the signal of the third control signal terminal CKD, so that in the reset phase, the first adjustment circuit increases the potential of the first pull-down node QB1 after the first pull-down node QB1 changes from being at low level to being at high level under control of the third control signal terminal CKD. For example, in a transition phase from the period P5 to the period P6 (which may be defined as a time period between a rising edge of the signal of the third control signal terminal falling into the period P5 and a falling edge of the signal of the third control signal terminal falling into the period P6), the first control signal terminal CKA changes from being at low level to being at high level, the third control signal terminal CKD remains at high level, and the eleventh transistor T11 and the second transistor T2 are turned on, thereby providing the signal of the first control signal terminal CKA to the third pull-up node Q3. As the first control signal terminal CKA changes from being at low level to being at high level, the third pull-up node Q3 also changes from being at low level to being at high level. In the transition phase, as the third control signal terminal CKD remains at high level, the seventh transistor T7 is turned on, thereby transmitting the change from low level to high level of the third pull-up node Q3 to the first electrode of the third capacitor C3, causing the potential of the first pull-down node QB1 to be further increased under the bootstrap effect of the third capacitor C3.

In some embodiments, a valid level duration of the signal of the second control signal terminal CKB partially overlaps with a valid level duration of the signal of the fourth control signal terminal CKC, so that in the reset phase, the second adjustment circuit increases the potential of the second pull-down node QB2 after the second pull-down node QB2 changes from being at low level to being at high level under control of the fourth control signal terminal CKC. For example, in a transition phase from the period P7 to the period P8 (which may be defined as a time period between a rising edge of the signal of the fourth control signal terminal CKC falling into the period P7 and a falling edge of the signal of the fourth control signal terminal CKC falling into the period P8), the input signal terminal IN remains at high level, the second control signal terminal CKB changes from being at low level to being at high level, and the fourth control signal terminal CKC remains at high level. The low level of the fourth control signal terminal CKC causes the eighth transistor T8 to be turned on, thereby transmitting the change from low level to high level of the second control signal terminal CKB to the second pull-down node QB2, causing the potential of the second pull-down node QB2 to be further increased by the bootstrap effect of the fourth capacitor C4. The presence of the fifth capacitor C5 may prevent the node between the eighth transistor T8 and the fourth capacitor C1 from floating, thereby further stabilizing the potential of the second pull-down node QB.

According to embodiments of the present disclosure, by providing at least one of the first adjustment circuit and the second adjustment circuit, the potential of the first pull-down node and the potential of the second pull-down node may be further increased after being reset (i.e., after being reset to high level), thereby prolonging the leakage time length of the eleventh transistor T11 and/or the sixth transistor T6 and achieving the effect of preventing leakage.

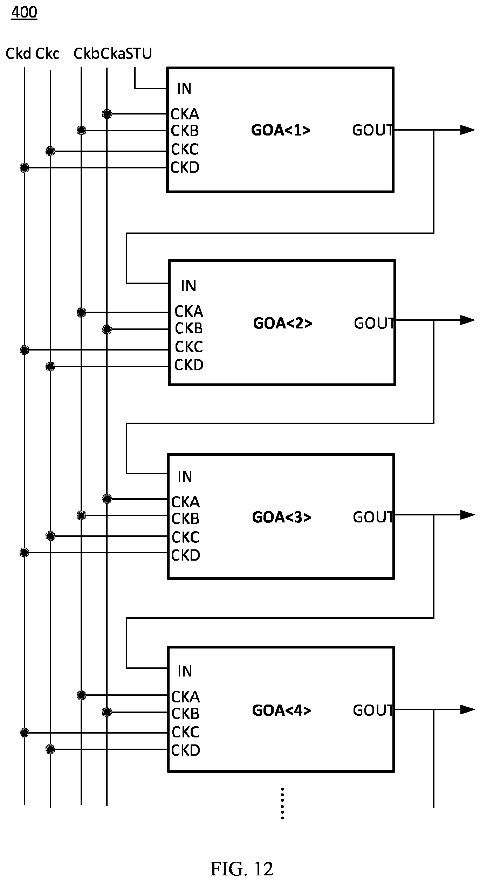

FIG. 12 shows a schematic block diagram of a gate driving circuit according to embodiments of the present disclosure.

As shown in FIG. 12, the gate driving circuit 400 may include a plurality of cascaded shift register units GOA<1>, GOA<2>, GOA<3>, GOA<4>, etc. At least one of these shift register units may be implemented by the shift register unit of any of the above embodiments.

As shown in FIG. 12, the output signal terminal of each stage of shift register unit is coupled to the input signal terminal of a next stage of shift register unit of the stage of shift register unit. For example, the output signal terminal GOUT of the first stage of shift register unit GOA<1> is coupled to the input signal terminal IN of the second stage of shift register unit GOA<2>, the output signal terminal GOUT of the second stage of shift register unit GOA<2> is coupled to the input signal terminal IN of the third stage of shift register unit GOA<3>, and so on. However, embodiments of the present disclosures are not limited to this. The output signal terminal of the n^{th} stage of shift register unit may be coupled to the input signal terminal of the (n+i)^{th} stage of shift register unit, where i may be set as desired. Embodiments of the present disclosures are not limited to this. The input signal terminal IN of the first stage of shift register unit GOA<1> receives a start signal STU, and a waveform of the start signal determines a waveform of the output signal of the output signal terminal GOUT. In other words, by adjusting a pulse width of the start signal, a pulse width of the output signal may be adjusted, thereby achieving pulse width modulation output.

As shown in FIG. 12, the first control signal terminals CKA of the odd-numbered stages of shift register units (such as GOA<1>, GOA<3>,...) are coupled to receive a first control signal Cka, the second control signal terminals CKB of the odd-numbered stages of shift register units (such as GOA<1>, GOA<3>,...) are coupled to receive a second control signal Ckb, the third control signal terminals CKD of the odd-numbered stages of shift register units (such as GOA<1>, GOA<3>,...) are coupled to receive a third control signal Ckd, the fourth control signal terminals CKC of the odd-numbered stages of shift register units (such as GOA<1>, GOA<3>,...) are coupled to receive a fourth control signal Ckc. On the contrary, the first control signal terminals CKA of the even-numbered stages of shift register units (such as GOA<2>, GOA<3>,...) are coupled to receive a second control signal Ckb, the second clock signal terminals CKB of the even-numbered stages of shift register units (such as GOA<2>, GOA<3>,...) are coupled to receive a first control signal Cka, the third control signal terminals CKD of the even-numbered stages of shift register units (such as GOA<2>, GOA<3>,...) are coupled to receive a fourth control signal Ckc, the fourth control signal terminals CKC of the even-numbered stages of shift register units (such as GOA<2>, GOA<3>,...) are coupled to receive a third control signal Ckd. However, embodiments of the present disclosures are not limited to this, and the clock coupling methods of the odd-numbered stages and the even-numbered stages may be interchanged, which will not be repeated here.

As shown in FIG. 12, the output signal terminal GOUT of each shift register unit is used to cascade with other shift register unit and also used to provide a scanning signal to sub-pixels in the display area. However, embodiments of the present disclosures are not limited to this. In a case that a separate control output terminal CR is provided in the shift register unit, the control output terminal CR may be used for the cascade coupling, and the output signal terminal GOUT may be used to provide the scanning signal to the sub-pixels in the display area.

Those skilled in the art may understand that embodiments described above are exemplary, and those skilled in the art may improve them. The structures described in various embodiments may be freely combined without structural or principle conflicts.

After elaborating on the preferred embodiments of the present disclosure, those skilled in the art can clearly understand that various changes and approaches can be made without departing from the scope and spirit of the accompanying claims, and the present disclosure is not limited to the implementation methods of the exemplary embodiments cited in the specification.

## Claims

1. A shift register unit, comprising:
an input circuit coupled to an input signal terminal of the shift register unit, a reference signal terminal of the shift register unit, a first pull-down node of the shift register unit, and a first pull-up node of the shift register unit, and configured to provide a signal of the input signal terminal to the first pull-up node and a signal of the reference signal terminal to the first pull-down node;
a first control circuit coupled to the first pull-down node and the first pull-up node, and configured to control a signal of the first pull-up node based on the first pull-down node, and control a signal of the first pull-down node based on the first pull-up node;
a second control circuit coupled to the first pull-down node of the shift register unit, the first pull-up node of the shift register unit, a second pull-down node of the shift register unit, and a second pull-up node of the shift register unit, and configured to provide the signal of the first pull-down node to the second pull-down node under control of the reference signal terminal, and control a signal of the second pull-up node based on the first pull-up node;
an output circuit coupled to the second pull-down node, the second pull-up node, the reference signal terminal, a clock signal terminal of the shift register unit, and an output signal terminal of the shift register unit, and configured to provide a signal of one of the clock signal terminal and the reference signal terminal to the output signal terminal under control of the second pull-down node and the second pull-up node; and
at least one of a first adjustment circuit and a second adjustment circuit, wherein the first adjustment circuit is coupled to the first pull-down node and the second control circuit, and the second adjustment circuit is coupled to the second pull-down node and the output circuit.

2. The shift register unit according to claim 1, wherein the first adjustment circuit is configured to decrease a potential of the first pull-down node after the first pull-down node is reset, and the second adjustment circuit is configured to decrease a potential of the second pull-down node after the second pull-down node is reset.

3. The shift register unit according to claim 1 or 2, wherein the second control circuit comprises:
a first control sub-circuit coupled to the first pull-down node, a first control signal terminal of the shift register unit, and a third pull-up node of the shift register unit, and configured to provide a signal of the first control signal terminal to the third pull-up node under control of the first pull-down node;
a second control sub-circuit coupled to the reference signal terminal, the first pull-down node, and the second pull-down node, and configured to provide the signal of the first pull-down node to the second pull-down node under control of the signal of the reference signal terminal;
a third control sub-circuit coupled to the first pull-up node, the reference signal terminal, and the third pull-up node, and configured to provide the signal of the reference signal terminal to the third pull-up node under control of the first pull-up node; and
a fourth control sub-circuit coupled to the second pull-up node, the third pull-up node, and a second control signal terminal of the shift register unit, and configured to provide a signal of the third pull-up node to the second pull-up node under control of the signal of the first pull-up node and a signal of the second control signal terminal.

4. The shift register unit according to claim 3, wherein the first control sub-circuit comprises a first transistor, a gate of the first transistor is coupled to the first pull-down node, a first electrode of the first transistor is coupled to the first control signal terminal, and a second electrode of the first transistor is coupled to the third pull-up node;
wherein the second control sub-circuit comprises a second transistor, a gate of the second transistor is coupled to the reference signal terminal, a first electrode of the second transistor is coupled to the first pull-down node, and a second electrode of the second transistor is coupled to the second pull-down node;
wherein the third control sub-circuit comprises a third transistor, a gate of the third transistor is coupled to the first pull-up node, a first electrode of the third transistor is coupled to the reference signal terminal, and a second electrode of the third transistor is coupled to the third pull-up node; and
wherein the fourth control sub-circuit comprises a fourth transistor and a fifth transistor, a gate of the fourth transistor is coupled to the first pull-up node, a first electrode of the fourth transistor is coupled to the third pull-up node, and a second electrode of the fourth transistor is coupled to the second pull-up node; a gate of the fifth transistor is coupled to the second control signal terminal, a first electrode of the fifth transistor is coupled to the third pull-up node, and a second electrode of the fifth transistor is coupled to the second pull-up node.

5. The shift register unit according to claim 3 or 4, wherein the first adjustment circuit comprises a sixth transistor and a first capacitor; and
wherein the sixth transistor and the first capacitor are coupled in series between the first pull-down node and the third pull-up node, and a gate of the sixth transistor is coupled to a third control signal terminal.

6. The shift register unit according to claim 5, wherein a first electrode of the sixth transistor is coupled to the third pull-up node, a second electrode of the sixth transistor is coupled to a first electrode of the first capacitor, and a second electrode of the first capacitor is coupled to the first pull-down node.

7. The shift register unit according to claim 5, wherein a first electrode of the first capacitor is coupled to the third pull-up node, a second electrode of the first capacitor is coupled to a first electrode of the sixth transistor, and a second electrode of the sixth transistor is coupled to the first pull-down node.

8. The shift register unit according to any one of claims 1 to 7, wherein the second adjustment circuit comprises a seventh transistor, a second capacitor, and a third capacitor; and
wherein a gate of the seventh transistor is coupled to a fourth control signal terminal of the shift register unit, a first electrode of the seventh transistor is coupled to a second control signal terminal of the shift register unit, a second electrode of the seventh transistor is coupled to a first electrode of the second capacitor, a second electrode of the second capacitor is coupled to the second pull-down node, a first electrode of the third capacitor is coupled to the reference signal terminal, and a second electrode of the third capacitor is coupled to the second electrode of the seventh transistor.

9. The shift register unit according to claim 8, wherein the second adjustment circuit further comprises an eighth transistor and a ninth transistor; and
wherein a gate of the eighth transistor is coupled to the reference signal terminal, the second electrode of the second transistor is coupled to a first electrode of the eighth transistor at an intermediate node, a second electrode of the eighth transistor is coupled to the second pull-down node; a gate of the ninth transistor is coupled to the second pull-down node, a first electrode of the ninth transistor is coupled to the reference signal terminal, and a second electrode of the ninth transistor is coupled to the intermediate node.

10. The shift register unit according to any one of claims 1 to 9, wherein the reference signal terminal comprises a first reference signal terminal and a second reference signal terminal, and a potential of the second reference signal terminal is lower than a potential of the first reference signal terminal; and
wherein the input circuit is coupled to the first reference signal terminal or the second reference signal terminal, and the output circuit is coupled to the first reference signal terminal.

11. The shift register unit according to claim 10, wherein the second adjustment circuit comprises a seventh transistor, a second capacitor, and a third capacitor; and
wherein a first electrode of the third capacitor is coupled to the first reference signal terminal.

12. The shift register unit according to claim 11, wherein the second adjustment circuit further comprises an eighth transistor and a ninth transistor; and
wherein a first electrode of the ninth transistor is coupled to the second reference signal terminal.

13. The shift register unit according to any one of claims 10 to 12, wherein the input circuit comprises a tenth transistor and an eleventh transistor;
wherein a gate of the tenth transistor is coupled to a first control signal terminal, a first electrode of the tenth transistor is coupled to the first reference signal terminal or the second reference signal terminal, and a second electrode of the tenth transistor is coupled to the first pull-down node; and
wherein a gate of the eleventh transistor is coupled to the first control signal terminal, a first electrode of the eleventh transistor is coupled to the input signal terminal, and a second electrode of the eleventh transistor is coupled to the first pull-up node.

14. The method according to claim 13, wherein at least one of the tenth transistor and the second transistor is a low temperature poly-silicon transistor.

15. The shift register unit according to any one of claims 1 to 14, wherein the output circuit comprises a twelfth transistor, a thirteenth transistor, and a fourth capacitor;
wherein a gate of the twelfth transistor is coupled to the second pull-down node, a first electrode of the twelfth transistor is coupled to the reference signal terminal, and a second electrode of the twelfth transistor is coupled to the output signal terminal;
wherein a gate of the thirteenth transistor is coupled to the second pull-up node, a first electrode of the thirteenth transistor is coupled to the clock signal terminal, and a second electrode of the thirteenth transistor is coupled to the output signal terminal; and
wherein a first electrode of the fourth capacitor is coupled to the second pull-up node, and a second electrode of the fourth capacitor is coupled to the output signal terminal.

16. The shift register unit according to any one of claims 1 to 15, further comprising a cascaded output circuit coupled to the first pull-down node, the first pull-up node, a power signal terminal, a second control signal terminal of the shift register unit, and a cascaded output terminal of the shift register unit, and configured to provide a signal of one of the power signal terminal and the second control signal terminal to the cascaded output terminal under control of the first pull-down node and the first pull-up node.

17. The shift register unit according to claim 16, wherein the cascaded output circuit comprises a fourteenth transistor, a fifteenth transistor, a fifth capacitor, and a sixth capacitor.

18. The shift register unit according to claim 17, wherein the cascaded output circuit further comprises a sixteenth transistor through which a gate of the fifteenth transistor is coupled to the first pull-up node, wherein a gate of the sixteenth transistor is coupled to the reference signal terminal, a first electrode of the sixteenth transistor is coupled to the first pull-up node, and a second electrode of the sixteenth transistor is coupled to the gate of the fifteenth transistor.

19. The shift register unit according to any one of claims 1 to 18, wherein the first control circuit comprises a seventeenth transistor, an eighteenth transistor, and a nineteenth transistor;
wherein a gate of the seventeenth transistor is coupled to the first pull-up node, a first electrode of the seventeenth transistor is coupled to a first control signal terminal, and a second electrode of the seventeenth transistor is coupled to the first pull-down node;
wherein a gate of the eighteenth transistor is coupled to the first pull-down node, a first electrode of the eighteenth transistor is coupled to a power signal terminal, and a second electrode of the eighteenth transistor is coupled to a first electrode of the nineteenth transistor; and
wherein a gate of the nineteenth transistor is coupled to a second control signal terminal, and a second electrode of the nineteenth transistor is coupled to the first pull-up node.

20. The shift register unit according to any one of claims 1 to 19, wherein at least one transistor in the input circuit, the first control circuit, the second control circuit, the first adjustment circuit, the second adjustment circuit, and the output circuit is a P-type transistor.

21. A shift register unit, comprising:
an input circuit coupled to an input signal terminal of the shift register unit, a power signal terminal of the shift register unit, a first pull-down node of the shift register unit, and a first pull-up node of the shift register unit, and configured to provide a signal of the input signal terminal to the first pull-down node and a signal of the power signal terminal to the first pull-up node;
a first control circuit coupled to the first pull-down node and the first pull-up node, and configured to control a signal of the first pull-up node based on the first pull-down node, and control a signal of the first pull-down node based on the first pull-up node;
a second control circuit coupled to the first pull-down node of the shift register unit, the first pull-up node of the shift register unit, a second pull-down node of the shift register unit, and a second pull-up node of the shift register unit, and configured to control a signal of the second pull-down node based on the first pull-down node, and provide the signal of the first pull-up node to the second pull-up node under control of the power signal terminal;
an output circuit coupled to the second pull-down node, the second pull-up node, the power signal terminal, a reference signal terminal of the shift register unit, and an output signal terminal of the shift register unit, and configured to provide a signal of one of the power signal terminal and the reference signal terminal to the output signal terminal under control of the second pull-down node and the second pull-up node; and
at least one of a first adjustment circuit and a second adjustment circuit, wherein the first adjustment circuit is coupled to the first pull-down node and the second control circuit, and the second adjustment circuit is coupled to the second pull-down node and the output circuit.

22. The shift register unit according to claim 21, wherein the first adjustment circuit is configured to increase a potential of the first pull-down node after the first pull-down node is reset, and the second adjustment circuit is configured to increase a potential of the second pull-down node after the second pull-down node is reset.

23. The shift register unit according to claim 21 or 22, wherein the second control circuit comprises:
a first control sub-circuit coupled to the first pull-up node, the first pull-down node, the power signal terminal, a first control signal terminal of the shift register unit, and a third pull-down node of the shift register unit, and configured to provide a signal of one of the power signal terminal and the first control signal terminal to the third pull-up node under control of the first pull-down node and the first pull-up node;
a second control sub-circuit coupled to the first pull-up node, the first pull-down node, the reference signal terminal, a second control signal terminal of the shift register unit, and a fourth pull-up node of the shift register unit, and configured to provide a signal of one of the reference signal terminal and the second control signal terminal to the fourth pull-up node under control of the first pull-down node and the first pull-up node;
a third control sub-circuit coupled to the second pull-up node, the fourth pull-up node, and the second control signal terminal, and configured to provide a signal of the fourth pull-up node to the second pull-up node under control of a signal of the second control signal terminal; and
a fourth control sub-circuit coupled to the power signal terminal, the first pull-down node, and the second pull-down node, and configured to provide the signal of the first pull-down node to the second pull-down node under control of the signal of the power signal terminal.

24. The shift register unit according to claim 23, wherein the first control sub-circuit comprises a first transistor and a second transistor, a gate of the first transistor is coupled to the first pull-up node, a first electrode of the first transistor is coupled to the power signal terminal, and a second electrode of the first transistor is coupled to the third pull-up node; a gate of the second transistor is coupled to the first pull-down node, a first electrode of the second transistor is coupled to the first control signal terminal, and a second electrode of the second transistor is coupled to the third pull-up node;
wherein the second control sub-circuit comprises a third transistor, a fourth transistor, a first capacitor, and a second capacitor, a gate of the third transistor is coupled to the first pull-up node, a first electrode of the third transistor is coupled to the second control signal terminal, and a second electrode of the third transistor is coupled to the fourth pull-up node; a first electrode of the first capacitor is coupled to the first pull-up node, and a second electrode of the first capacitor is coupled to the fourth pull-up node; a gate of the fourth transistor is coupled to the first pull-down node, a first electrode of the fourth transistor is coupled to the reference signal terminal, and a second electrode of the fourth transistor is coupled to the fourth pull-up node; a first electrode of the second capacitor is coupled to the first pull-down node, and a second electrode of the second capacitor is coupled to the reference signal terminal;
wherein the third control sub-circuit comprises a fifth transistor, a gate of the fifth transistor is coupled to the second control signal terminal, a first electrode of the fifth transistor is coupled to the fourth pull-up node, and a second electrode of the fifth transistor is coupled to the second pull-up node; and
wherein the fourth control sub-circuit comprises a sixth transistor, a gate of the sixth transistor is coupled to the power signal terminal, a first electrode of the sixth transistor is coupled to the first pull-down node, and a second electrode of the sixth transistor is coupled to the second pull-down node.

25. The shift register unit according to claim 23 or 24, wherein the first adjustment circuit comprises a seventh transistor and a third capacitor; and
wherein the seventh transistor and the third capacitor are coupled in series between the first pull-down node and the third pull-up node, and a gate of the seventh transistor is coupled to a third control signal terminal.

26. The shift register unit according to claim 25, wherein a first electrode of the seventh transistor is coupled to the third pull-up node, a second electrode of the seventh transistor is coupled to a first electrode of the third capacitor, and a second electrode of the third capacitor is coupled to the first pull-down node.

27. The shift register unit according to claim 25, wherein a first electrode of the third capacitor is coupled to the third pull-up node, a second electrode of the third capacitor is coupled to a first electrode of the seventh transistor, and a second electrode of the seventh transistor is coupled to the first pull-down node.

28. The shift register unit according to any one of claims 21 to 27, wherein the second adjustment circuit comprises an eighth transistor, a fourth capacitor, and a fifth capacitor; and
wherein a gate of the eighth transistor is coupled to a fourth control signal terminal of the shift register unit, a first electrode of the eighth transistor is coupled to a second control signal terminal of the shift register unit, a second electrode of the eighth transistor is coupled to a first electrode of the fourth capacitor, a second electrode of the fourth capacitor is coupled to the second pull-down node, a first electrode of the fifth capacitor is coupled to the power signal terminal, and a second electrode of the fifth capacitor is coupled to the second electrode of the eighth transistor.

29. The shift register unit according to any one of claims 23 to 28, wherein the second control circuit further comprises a ninth transistor, a gate of the ninth transistor is coupled to the first pull-down node, a first electrode of the ninth transistor is coupled to the reference signal terminal, and a second electrode of the ninth transistor is coupled to the second pull-up node.

30. The shift register unit according to any one of claims 21 to 29, wherein the input circuit comprises a tenth transistor and an eleventh transistor;
wherein a gate of the tenth transistor is coupled to a first control signal terminal, a first electrode of the tenth transistor is coupled to the power signal terminal, and a second electrode of the tenth transistor is coupled to the first pull-up node; and
wherein a gate of the eleventh transistor is coupled to the first control signal terminal, a first electrode of the eleventh transistor is coupled to the input signal terminal, and a second electrode of the eleventh transistor is coupled to the first pull-down node.

31. The method according to any one of claim 30, wherein at least one of the eleventh transistor and the sixth transistor is a low temperature poly-silicon transistor.

32. The shift register unit according to any one of claims 21 to 31, wherein the output circuit comprises a twelfth transistor, a thirteenth transistor, and a fourth capacitor;
wherein a gate of the twelfth transistor is coupled to the second pull-up node, a first electrode of the twelfth transistor is coupled to the reference signal terminal, and a second electrode of the twelfth transistor is coupled to the output signal terminal;
wherein a gate of the thirteenth transistor is coupled to the second pull-down node, a first electrode of the thirteenth transistor is coupled to the power signal terminal, and a second electrode of the thirteenth transistor is coupled to the output signal terminal; and
wherein a first electrode of the fourth capacitor is coupled to the second pull-up node, and a second electrode of the fourth capacitor is coupled to the reference signal terminal.

33. The shift register unit according to claim 32, wherein the output circuit further comprises a fourteenth transistor and a fifteenth transistor;
wherein the first electrode of the twelfth transistor is coupled to the reference signal terminal through the fourteenth transistor, a gate of the fourteenth transistor is coupled to the second pull-up node, a first electrode of the fourteenth transistor is coupled to the reference signal terminal, and a second electrode of the fourteenth transistor is coupled to the first electrode of the twelfth transistor; and
wherein a gate of the fifteenth transistor is coupled to the output signal terminal, a first electrode of the fifteenth transistor is coupled to the power signal terminal, and a second electrode of the fifteenth transistor is coupled to the first electrode of the twelfth transistor.

34. The shift register unit according to any one of claims 21 to 33, wherein the first control circuit comprises a sixteenth transistor, a seventeenth transistor, and an eighteenth transistor;
wherein a gate of the sixteenth transistor is coupled to the first pull-down node, a first electrode of the sixteenth transistor is coupled to a first control signal terminal, and a second electrode of the sixteenth transistor is coupled to the first pull-up node;
wherein a gate of the seventeenth transistor is coupled to the first pull-up node, a first electrode of the seventeenth transistor is coupled to the reference signal terminal, a second electrode of the seventeenth transistor is coupled to a first electrode of the eighteenth transistor; and
wherein a gate of the eighteenth transistor is coupled to a second control signal terminal, and a second electrode of the eighteenth transistor is coupled to the first pull-down node.

35. The shift register unit according to any one of claims 21 to 34, wherein at least one transistor in the input circuit, the first control circuit, the second control circuit, the first adjustment circuit, the second adjustment circuit, and the output circuit is an N-type transistor.

36. A method for controlling the shift register unit according to any one of claims 1 to 20, the method comprising:
in an input phase, providing, by the input circuit, the signal of the input signal terminal to the first pull-up node and the signal of the reference signal terminal to the first pull-down node;
in an output phase, controlling, by the first control circuit, the signal of the first pull-up node based on the first pull-down node, and controlling the signal of the first pull-down node based on the first pull-up node; providing, by the second control circuit, the signal of the first pull-up node to the second pull-up node and the signal of the first pull-down node to the second pull-down node, so that the second pull-up node is at low level and the second pull-down node is at high level; providing, by the output circuit, the signal of the clock signal terminal to the output signal terminal under control of the second pull-up node and the second pull-down node; and
in a reset phase, controlling, by the first control circuit, the signal of the first pull-up node based on the first pull-down node, and controlling the signal of the first pull-down node based on the first pull-up node; providing, by the second control circuit, the signal of the first pull-up node to the second pull-up node and the signal of the first pull-down node to the second pull-down node, so that the second pull-up node changes from being at low level to being at high level and the second pull-down node changes from being at high level to being at low level; providing, by the output circuit, the signal of the reference signal terminal to the output signal terminal under control of the second pull-up node and the second pull-down node,
wherein in the reset phase, the first adjustment circuit decreases a potential of the first pull-down node after the first pull-down node changes from being at high level to being at low level, and/or the second adjustment circuit decreases a potential of the second pull-down node after the second pull-down node changes from being at high level to being at low level.

37. The method according to claim 36, wherein the second control circuit is coupled to a first control signal terminal and a second control signal terminal, the first adjustment circuit is coupled to a third control signal terminal, and the second adjustment circuit is coupled to a fourth control signal terminal; and
wherein a valid level duration of a signal of the first control signal terminal partially overlaps with a valid level duration of a signal of the third control signal terminal, so that in the reset phase, the first adjustment circuit decreases the potential of the first pull-down node after the first pull-down node changes from being at high level to being at low level under control of the third control signal terminal; and/or a valid level duration of a signal of the second control signal terminal partially overlaps with a valid level duration of a signal of the fourth control signal terminal, so that in the reset phase, the second adjustment circuit decreases the potential of the second pull-down node after the second pull-down node changes from being at high level to being at low level under control of the fourth control signal terminal.

38. A method for controlling the shift register unit according to any one of claims 21 to 35, the method comprising:
in an input phase, providing, by the input circuit, the signal of the input signal terminal and the signal of the power signal terminal to the first pull-up node and the first pull-down node;
in an output phase, controlling, by the first control circuit, a potential of the first pull-up node based on the first pull-down node, and controlling a potential of the first pull-down node based on the first pull-up node; providing, by the second control circuit, the signal of the first pull-up node to the second pull-up node and the signal of the first pull-down node to the second pull-down node, so that the second pull-up node is at high level and the second pull-down node is at low level; providing, by the output circuit, a signal of the reference signal terminal to the output signal terminal under control of the second pull-up node and the second pull-down node; and
in a reset phase, controlling, by the first control circuit, the signal of the first pull-up node based on the first pull-down node, and controlling the signal of the first pull-down node based on the first pull-up node; providing, by the second control circuit, the signal of the first pull-up node to the second pull-up node and the signal of the first pull-down node to the second pull-down node, so that the second pull-up node changes from being at high level to being at low level and the second pull-down node changes from being at low level to being at high level; providing, by the output circuit, the signal of the power signal terminal to the output signal terminal under control of the second pull-up node and the second pull-down node,
wherein in the reset phase, the first adjustment circuit increases the potential of the first pull-down node after the first pull-down node changes from being at low level to being at high level, and/or the second adjustment circuit increases a potential of the second pull-down node after the second pull-down node changes from being at low level to being at high level.

39. The method according to claim 38, wherein the second control circuit is coupled to a first control signal terminal and a second control signal terminal, the first adjustment circuit is coupled to a third control signal terminal, and the second adjustment circuit is coupled to a fourth control signal terminal; and
wherein a valid level duration of a signal of the first control signal terminal partially overlaps with a valid level duration of a signal of the third control signal terminal, so that in the reset phase, the first adjustment circuit increases the potential of the first pull-down node after the first pull-down node changes from being at low level to being at high level under control of the third control signal terminal; and/or a valid level duration of a signal of the second control signal terminal partially overlaps with a valid level duration of a signal of the fourth control signal terminal, so that in the reset phase, the second adjustment circuit increases the potential of the second pull-down node after the second pull-down node changes from being at low level to being at high level under control of the fourth control signal terminal.

40. A gate driving circuit comprising a plurality of cascaded shift register units, wherein the shift register unit is the shift register unit according to any one of claims 1 to 37.
